# EUROPEAN PATENT APPLICATION

(11) **EP 4 845 366 A1**
(43) Date of publication of application: **25.11.2026**
(21) Application number: 26179686.6
(22) Date of filing: 19.05.2026
(51) Int. Cl.: H10K 59/122, H10K 59/124, H10K 59/131

(54) **ELECTRONIC DEVICE AND METHOD FOR MANUFACTURING THE SAME**

(30) Priority: 21.05.2025 KR 20250066145
(71) Applicant: Samsung Display Co., Ltd., Yongin-si, Gyeonggi-do 17113 (KR)
(72) Inventor: LEE, SUNGEUN, 17113 Yongin-si (KR); KANG, KI NYENG, 17113 Yongin-si (KR); SONG, KEUNKYU, 17113 Yongin-si (KR); KIM, DONG-HYUN, 17113 Yongin-si (KR); KIM, SIKWANG, 17113 Yongin-si (KR); NAM, YUNYONG, 17113 Yongin-si (KR); LEE, JAEHUN, 17113 Yongin-si (KR)
(74) Representative: Taor, Simon Edward William

(57) **Abstract**

An electronic device including a display panel which includes a substrate, a pixel unit on the substrate, a pixel defining layer that has openings defined therein to overlap light emitting areas, a barrier wall on the pixel defining layer, and pads that are connected to pixels and that overlap the non-display area, each pad including a first conductive pattern, a second conductive pattern on the first conductive pattern, and a third conductive pattern on the second conductive pattern. A width by which a second barrier wall pattern is exposed from a first barrier wall pattern is greater than a width by which a third conductive pattern is exposed from the second conductive pattern.

## Description

### CROSS-REFERENCE TO RELATED APPLICATION

The present application claims priority to and the benefit of Korean Patent Application No. 10-2025-0066145, filed on May 21, 2025, in the Korean Intellectual Property Office.

### BACKGROUND

Aspects of some embodiments of the present disclosure described herein relate to an electronic device and a manufacturing method thereof.

Electronic devices, such as a smart phone, a digital camera, a notebook computer, a car navigation device, and a smart television, which display images to a user include an electronic device for displaying the image. The electronic device generates the images and displays the generated images to the user through a display screen.

The electronic device includes a plurality of pixels for generating the images and a plurality of lines connected to the pixels. The pixels are driven by driving signals received through the lines.

In large-area electronic devices, such as a tablet computer and a smart television, there may be a difference between driving voltages transferred to respective pixels, and a design for compensating for the difference is required.

The above information disclosed in this Background section is only for enhancement of understanding of the background and therefore the information discussed in this Background section does not necessarily constitute prior art.

### SUMMARY

Aspects of some embodiments of the present disclosure described herein relate to an electronic device and a manufacturing method thereof, and for example, relate to an electronic device with relatively improved display quality and a method for manufacturing the same.

Aspects of some embodiments of the present disclosure include an electronic device for providing a relatively uniform driving voltage to pixels. In addition, aspects of some embodiments of the present disclosure include an electronic device for relatively improving reliability of pads included in a display panel and a method for manufacturing the electronic device.

According to some embodiments of the present disclosure, an electronic device includes a display panel including a display area and a non-display area that surrounds the display area and includes a pad area and a driver that receives image data and a display brightness value from a processor and drives the display panel based on the image data and the display brightness value. According to some embodiments, the display panel includes a substrate including light emitting areas that overlap the display area and a non-light emitting area between the light emitting areas, a pixel unit that overlaps the display area and includes pixels, each of which includes a transistor and a light emitting element connected with the transistor, a pixel defining layer that overlaps the non-light emitting area and has openings defined therein to overlap the light emitting areas, a barrier wall including a first barrier wall pattern on the pixel defining layer and a second barrier wall pattern on the first barrier wall pattern, and pads that are connected to the pixels and that overlap the non-display area, each pad including a first conductive pattern, a second conductive pattern on the first conductive pattern, and a third conductive pattern on the second conductive pattern. According to some embodiments, a width by which the second barrier wall pattern is exposed from the first barrier wall pattern is greater than a width by which the third conductive pattern is exposed from the second conductive pattern.

According to some embodiments, the first barrier wall pattern may include aluminum, and the second barrier wall pattern may include titanium.

According to some embodiments, the second conductive pattern may include the same material as the first barrier wall pattern, and the first conductive pattern and the third conductive pattern may include the same material as the second conductive pattern.

According to some embodiments, the first barrier wall pattern may have a smaller width than the second barrier wall pattern, and the first barrier wall pattern may have a greater thickness than the second barrier wall pattern.

According to some embodiments, the second conductive pattern may have a width smaller than a width of the first conductive pattern and a width of the third conductive pattern, and the second conductive pattern may have a thickness greater than a thickness of the first conductive pattern and a thickness of the third conductive pattern.

According to some embodiments, the barrier wall may further include a first insulating pattern on the pixel defining layer and a second insulating pattern between the first insulating pattern and the first barrier wall pattern.

According to some embodiments, the second insulating pattern may have a width greater than a width of the first barrier wall pattern and a width of the first insulating pattern.

According to some embodiments, the first insulating pattern may include at least one of indium zinc oxide, indium gallium zinc oxide, or indium tin oxide, and the second insulating pattern may include at least one of silicon oxide, silicon oxy nitride, or silicon nitride.

According to some embodiments, each of the light emitting elements may include a first electrode having at least a portion exposed by the opening, a common layer on the first electrode, and a second electrode on the common layer, and the second electrode may have a one-body shape commonly included in the pixels.

According to some embodiments, the electronic device may further include a dummy pattern on an upper surface of the second barrier wall pattern, and the dummy pattern may include the same material as the common layer.

According to some embodiments, the second electrode may extend from the light emitting area to the non-light emitting area and may cover a side surface of the first barrier wall pattern, a lower surface of the second barrier wall pattern exposed from the first barrier wall pattern, and the dummy pattern.

According to some embodiments, the display panel may further include a first organic insulating layer between the transistors and the light emitting elements and a second organic insulating layer on the first organic insulating layer. According to some embodiments, the pixel defining layer may be on the second organic insulating layer in the display area, and the pad may be on the first organic insulating layer in the pad area.

According to some embodiments, the second organic insulating layer may not be in the pad area.

According to some embodiments, the electronic device may further include a flexible circuit board in the pad area and coupled with the pads.

According to some embodiments of the present disclosure, an electronic device manufacturing method includes a step of forming a first organic insulating layer on a working substrate including a display area and a non-display area including a pad area, a step of forming a conductive pattern on the first organic insulating layer overlapping the pad area and forming a pad on the first organic insulating layer overlapping the pad area, a step of forming a second organic insulating layer on the first organic insulating layer to cover the conductive pattern and the pad, a step of forming an anode and a pixel defining layer on the second organic insulating layer overlapping the display area, a step of forming a first insulating pattern layer on the second organic insulating layer overlapping the display area and the non-display area, a step of forming a second insulating pattern layer on the first insulating pattern layer overlapping the display area, a step of forming a barrier wall pattern on the second insulating pattern layer overlapping the pixel defining layer, a step of forming a second insulating pattern such that the second insulating pattern overlaps the barrier wall pattern, by making the second insulating pattern layer subject to patterning, a step of forming a photoresist pattern on the first insulating pattern layer overlapping the display area, a step of removing the first insulating pattern layer overlapping the pad area, a step of forming a first insulating pattern such that the first insulating pattern overlaps the second insulating pattern, by making the first insulating pattern layer, which overlaps the display area, subject to patterning, and a step of exposing the pad by removing the second organic insulating layer overlapping the pad area.

According to some embodiments, the first insulating pattern layer may include at least one of indium zinc oxide, indium gallium zinc oxide, or indium tin oxide, and the second insulating pattern layer may include at least one of silicon oxide, silicon oxy nitride, or silicon nitride.

According to some embodiments, the barrier wall pattern may include a first barrier wall pattern that is on the second insulating pattern and that includes aluminum and a second barrier wall pattern that is on the first barrier wall pattern and that includes titanium.

According to some embodiments, each of the conductive pattern and the pad may include a first conductive pattern including titanium, a second conductive pattern that is on the first conductive pattern and that includes aluminum, and a third conductive pattern that is on the second conductive pattern and that includes titanium.

According to some embodiments, a width by which the second barrier wall pattern is exposed from the first barrier wall pattern may be greater than a width by which the third conductive pattern is exposed from the second conductive pattern.

According to some embodiments, the photoresist pattern may not be on the first insulating pattern layer that overlaps the pad area.

According to an aspect, there is provided an electronic device as set out in claim 1. Additional features are set out in claims 2 to 11. According to an aspect, there is provided a method as set out in claim 12. Additional features are set out in claims 13 to 15.

### BRIEF DESCRIPTION OF THE DRAWINGS

The above and other aspects and features of embodiments according to the present disclosure will become more apparent by describing in more detail aspects of some embodiments thereof with reference to the accompanying drawings.
FIG. 1A is a block diagram of an electronic device according to some embodiments of the present disclosure.
FIG. 1B illustrates schematic views of electronic devices according to some embodiments of the present disclosure.
FIG. 1C is a perspective view of an electronic device according to some embodiments of the present disclosure.
FIG. 2 is a sectional view of the electronic device according to some embodiments of the present disclosure.
FIG. 3 is a sectional view of a display panel according to some embodiments of the present disclosure.
FIG. 4A is a block diagram of a display module according to some embodiments of the present disclosure.
FIG. 4B is an equivalent circuit of one of the pixels illustrated in FIG. 4A.
FIG. 4C is a plan view of the display panel according to some embodiments of the present disclosure.
FIG. 5 is a plan view of a display area according to some embodiments of the present disclosure.
FIG. 6 is a sectional view taken along the line I-I' of FIG. 5.
FIG. 7 is a sectional view taken along the line II-II' of FIG. 5.
FIG. 8A is a sectional view taken along the line III-III' of FIG. 5.
FIG. 8B is a sectional view of a portion of the display area according to some embodiments of the present disclosure.
FIGS. 9A to 9G are sectional views illustrating an electronic device manufacturing method according to some embodiments of the present disclosure.

### DETAILED DESCRIPTION

In this specification, when a component (or, an area, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description. As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship between components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, aspects of some embodiments of the present disclosure will be described with reference to the accompanying drawings.

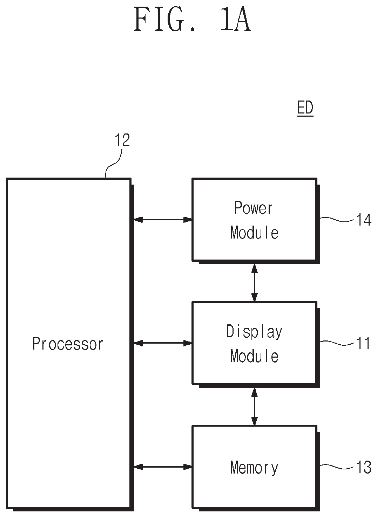

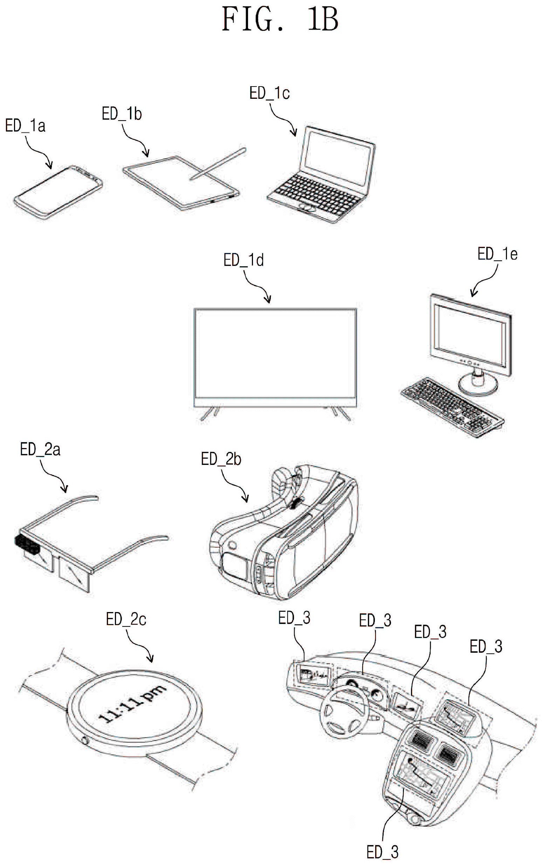

FIG. 1A is a block diagram of an electronic device according to some embodiments. FIG. 1B illustrates schematic views of electronic devices according to various embodiments.

Referring to FIG. 1A, the electronic device ED according to some embodiments may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), or a controller.

Data information required or utilized for operation of the processor 12 or the display module 11 may be stored in the memory 13. When the processor 12 executes an application stored in the memory 13, an image data signal and/or an input control signal may be transferred to the display module 11, and the display module 11 may process the provided signal and may output image information through a display screen.

The power module 14 may include a power supply module such as a power adapter or a battery device and a power conversion module that converts power supplied by the power supply module and generates power required for operation of the electronic device ED.

At least one of the components of the electronic device ED described above may be included in a display device. In addition, some of the separate modules functionally included in one module may be included in the display device, and the others may be provided separately from the display device. For example, the display device may include the display module 11, and the processor 12, the memory 13, and the power module 14 may be provided in the form of other devices in the electronic device ED rather than the display device.

Referring to FIG. 1B, various electronic devices to which a display device is applied may include not only electronic devices for displaying images, such as a smart phone ED_1a, a tablet PC ED_1b, a laptop computer ED_1c, a TV ED_1d, and a desk monitor ED_1e, but also wearable electronic devices including a display module, such as smart glasses ED_2a, a head mounted display ED_2b, and a smart watch ED_2c, and vehicle electronic devices ED_3 including a display module, such as center information displays (CID) located on an instrument panel, a center fascia, and a dashboard of a vehicle and a room mirror display.

A display device according to some embodiments may be applied to various electronic devices. An electronic device according to some embodiments may include the display device described above and may further include modules or devices having other additional functions, in addition to the display device.

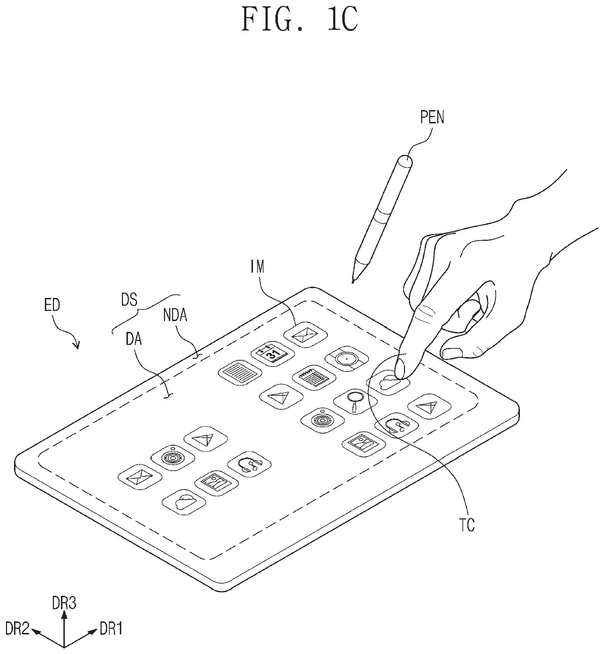

FIG. 1C is a perspective view of an electronic device according to some embodiments of the present disclosure. The electronic devices described in more detail with reference to FIGS. 1A and 1B may be applied to the electronic device ED to be described with reference to FIG. 1C. For example, the smart phone ED_1a described with reference to FIG. 1B may correspond to the electronic device ED of FIG. 1C.

Referring to FIG. 1C, the electronic device ED according to some embodiments of the present disclosure may have long sides extending parallel to each other in a first direction DR1 and short sides extending parallel to each other in a second direction DR2 crossing the first direction DR1. The corners of the electronic device ED that connect the long sides and the short sides may have a curved shape. The corners of the electronic device ED that have a curved shape may be defined as rounded corners. The shape of the electronic device ED may be defined as a rounded quadrangular shape. However, this is only an example of the shape of the electronic device ED, and the electronic device ED of embodiments is not limited to a rounded quadrangular shape.

Hereinafter, a direction perpendicular (or substantially perpendicular) to a plane defined by the first direction DR1 and the second direction DR2 is defined as a third direction DR3. In addition, the expressions "when viewed from above the plane" or "in a plan view" as used herein refers to a view along the third direction DR3 (e.g., toward a display surface of the electronic device ED).

The front surface of the electronic device ED may be defined as a display surface DS, and the display surface DS may have the plane defined by the first direction DR1 and the second direction DR2. Images IM generated by the electronic device ED may be provided to a user through the display surface DS.

The display surface DS may include a display area DA and a non-display area NDA around (e.g., in a periphery or outside a footprint of) the display area DA. The display area DA may display images, and the non-display area NDA may not display images. The non-display area NDA may surround (e.g., in the periphery or outside a footprint of) the display area DA and may define the border of the electronic device ED that is printed in a certain color.

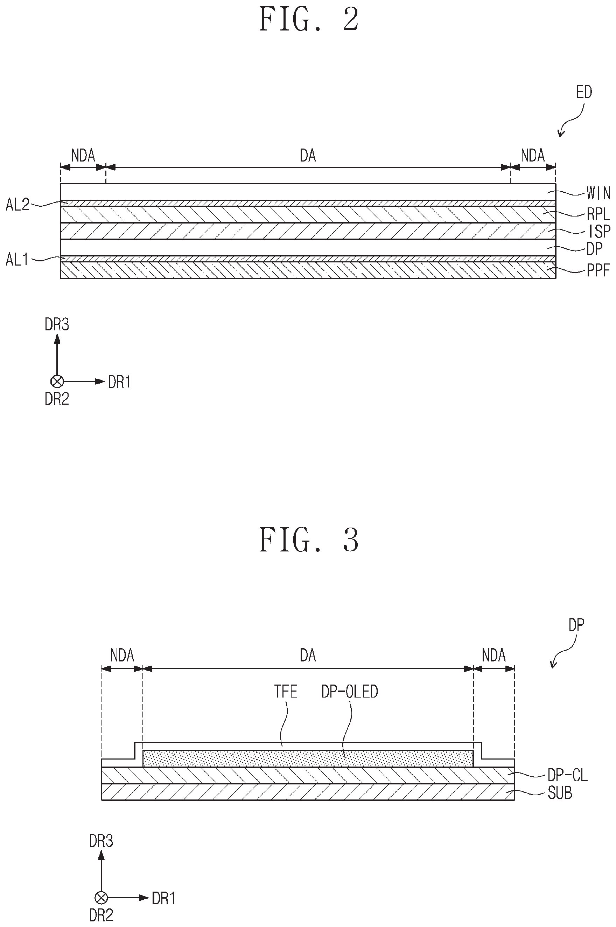

The display area DA may have a rounded quadrangular shape depending on the shape of the electronic device ED. For example, the display area DA may include sides of a quadrangle that extend in the first direction DR1 and the second direction DR2 and rounded corners that connect the sides. Among the four sides, the sides extending in the first direction DR1 may be defined as long sides, and the sides extending in the second direction DR2 may be defined as short sides. The non-display area NDA may be an area in which driving elements and wiring for driving a display panel DP (refer to FIG. 2) included in the electronic device ED are located.

The electronic device ED may sense inputs applied from outside the electronic device ED. For example, the electronic device ED may sense a first input by a touch pen PEN and a second input by a touch TC. The touch pen PEN may be defined as an input device.

The touch pen PEN may be an active pen that outputs a signal. The second input by the touch TC may include various types of external inputs such as a part of the user's body, light, heat, or pressure.

The electronic device ED and the touch pen PEN may bidirectionally communicate with each other. The electronic device ED may provide an uplink signal to the touch pen PEN. For example, the uplink signal may include information such as panel information and protocol version, but embodiments are not particularly limited thereto.

The touch pen PEN may provide a downlink signal to the electronic device ED. The downlink signal may include a synchronization signal or status information of the touch pen PEN. For example, the downlink signal may include coordinate information of the touch pen PEN, battery information of the touch pen PEN, tilt information of the touch pen PEN, and/or various pieces of information stored in the touch pen PEN, but embodiments according to the present disclosure are not particularly limited thereto.

The electronic device ED may be used in large electronic devices such as a television, a monitor, and a billboard. In addition, the electronic device ED may be used in small and medium-sized electronic devices such as a personal computer, a notebook computer, a personal digital assistant, a car navigation device, a game machine, a smart phone, a tablet computer, and a camera. However, these are merely illustrative, and the electronic device ED may be used in other electronic devices without departing from the scope of embodiments according to the present disclosure.

FIG. 2 is a sectional view of the electronic device according to some embodiments of the present disclosure. FIG. 3 is a sectional view of the display panel according to some embodiments of the present disclosure.

FIG. 2 is a view illustrating a cross-section of the electronic device illustrated in FIG. 1C. In FIG. 2, a cross-section of the electronic device ED viewed in the second direction DR2 is illustrated as an example. In FIG. 2, some of the components of the electronic device ED described with reference to FIG. 1C are omitted.

Referring to FIG. 2, the electronic device ED may include the display panel DP, an input sensor ISP, an anti-reflective layer RPL, a window WIN, a panel protection film PPF, a first adhesive layer AL1, and a second adhesive layer AL2.

The display panel DP according to some embodiments of the present disclosure may be an emissive display panel. For example, the display panel DP may be an organic light emitting display panel or an inorganic light emitting display panel. A light emitting layer of the organic light emitting display panel may include an organic luminescent material. A light emitting layer of the inorganic light emitting display panel may include a quantum dot and a quantum rod. Hereinafter, it will be described that the display panel DP is an organic light emitting display panel, but embodiments according to the present disclosure are not limited thereto.

The input sensor ISP may be located on the display panel DP. The input sensor ISP may include a plurality of sensing parts for sensing an external input in a capacitive type. The input sensor ISP may be directly manufactured on the display panel DP when the electronic device ED is manufactured. Accordingly, the input sensor ISP according to some embodiments may be directly located on the display panel DP. However, without being limited thereto, the input sensor ISP may be manufactured as a panel separate from the display panel DP and may be attached to the display panel DP by an adhesive layer.

The anti-reflective layer RPL may be located on the input sensor ISP. The anti-reflective layer RPL may be directly manufactured on the input sensor ISP when the electronic device ED is manufactured. However, without being limited thereto, the anti-reflective layer RPL may be manufactured as a separate panel and may be attached to the input sensor ISP by an adhesive layer.

The anti-reflective layer RPL may be defined as a film for preventing or reducing reflection of external light. The anti-reflective layer RPL may decrease the reflectance of external light incident toward the display panel DP from above the electronic device ED. The external light may not be visible to the user due to the anti-reflective layer RPL.

When the external light traveling toward the display panel DP is reflected by the display panel DP and then provided back to the user, the user may visually recognize the external light as in a mirror. To prevent or reduce such a phenomenon, for example, the anti-reflective layer RPL may include a plurality of color filters that display the same colors as pixels of the display panel DP.

The color filters may filter the external light in the same colors as the pixels. In this case, the external light may not be visible to the user. However, without being limited thereto, the anti-reflective layer RPL may include a phase retarder and/or a polarizer to decrease the reflectance of the external light.

The window WIN may be located on the anti-reflective layer RPL. The window WIN may protect the display panel DP, the input sensor ISP, and the anti-reflective layer RPL from external scratches and impacts.

The panel protection film PPF may be located under the display panel DP. The panel protection film PPF may protect the bottom of the display panel DP. The panel protection film PPF may include a flexible plastic material such as polyethylene terephthalate (PET).

The first adhesive layer AL1 may be located between the display panel DP and the panel protection film PPF, and the display panel DP and the panel protection film PPF may be bonded to each other by the first adhesive layer AL1. The second adhesive layer AL2 may be located between the window WIN and the anti-reflective layer RPL, and the window WIN and the anti-reflective layer RPL may be bonded to each other by the second adhesive layer AL2.

According to the present disclosure, a sensor may be located under the display panel DP overlapping the display area DA. The sensor may include at least one of a camera sensor, a speaker sensor, an IR sensor, an illuminance sensor, or a heat detection sensor.

FIG. 3 is a view illustrating a cross-section of the display panel illustrated in FIG. 2. For example, in FIG. 3, a cross-section of the display panel DP viewed in the second direction DR2 is illustrated.

Referring to FIG. 3, the display panel DP may include a substrate SUB, a circuit element layer DP-CL located on the substrate SUB, a display element layer DP-OLED located on the circuit element layer DP-CL, and a thin film encapsulation layer TFE located on the display element layer DP-OLED.

The substrate SUB may include a display area DA and a non-display area NDA around (e.g., in a periphery or outside a footprint of) the display area DA. The substrate SUB may include glass or may include a flexible plastic material such as polyimide. The display element layer DP-OLED may be located on the display area DA.

A plurality of pixels may be located in the circuit element layer DP-CL and the display element layer DP-OLED. Each of the pixels may include a transistor located in the circuit element layer DP-CL and a light emitting element located in the display element layer DP-OLED and connected to the transistor.

The thin film encapsulation layer TFE may be located on the circuit element layer DP-CL to cover the display element layer DP-OLED. The thin film encapsulation layer TFE may protect the pixels from moisture, oxygen, and external foreign matter.

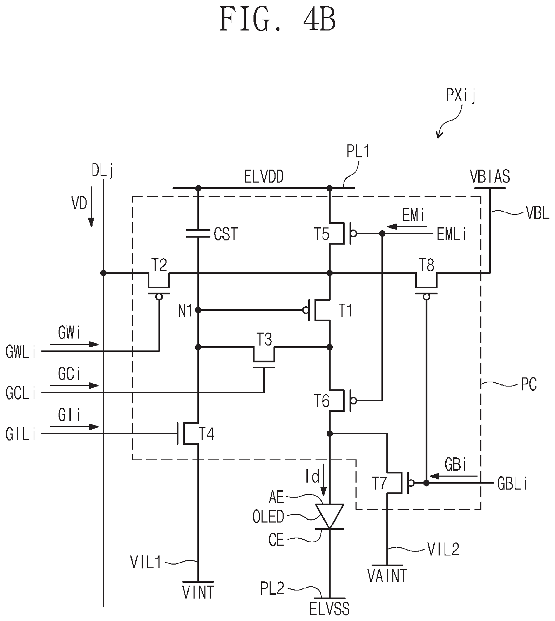

The thin film encapsulation layer TFE may be located on a light emitting element OLED and may cover the light emitting element OLED. The thin film encapsulation layer TFE may include a first inorganic layer LIL located on pixels PXij (refer to FIG. 4B), a second inorganic layer UIL located over the first inorganic layer LIL, and an organic layer OL located between the first inorganic layer LIL and the second inorganic layer UIL.

The first inorganic layer LIL and the second inorganic layer UIL may include an inorganic material and may protect the pixels PXij (refer to FIG. 4B) from moisture/oxygen. The organic layer OL may include an organic material and may protect the pixels PXij (refer to FIG. 4B) from foreign matter such as dust particles. The organic layer OL may be formed through a solution process such as spin coating, slit coating, or an inkjet process.

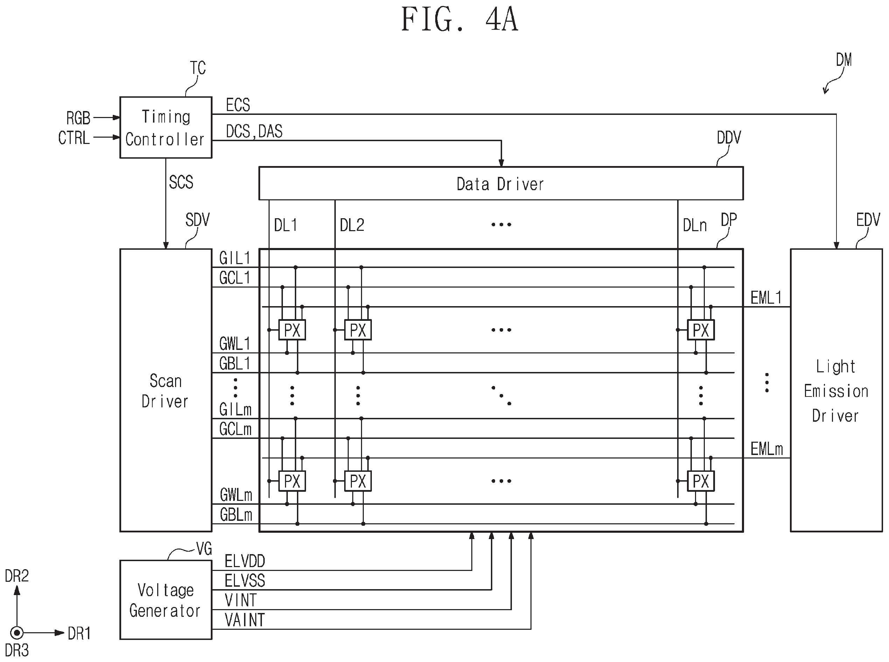

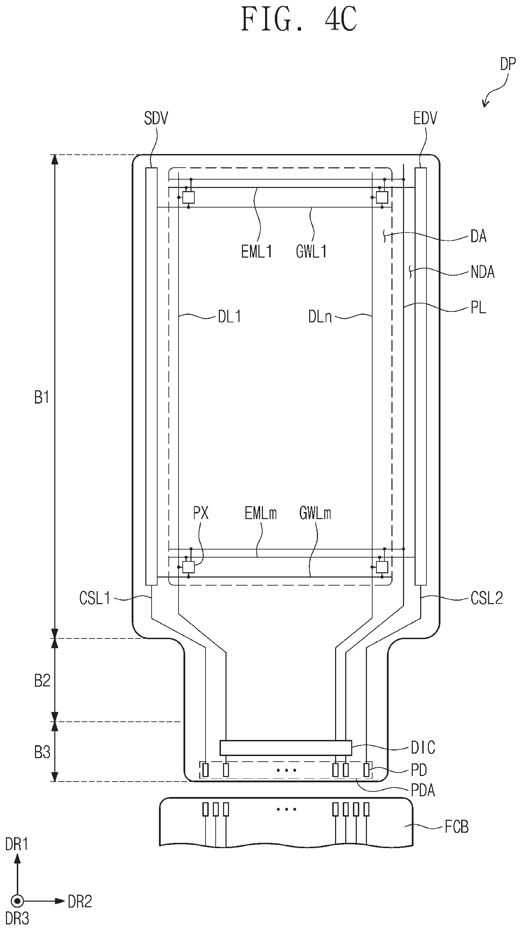

FIG. 4A is a block diagram of a display module according to some embodiments of the present disclosure. FIG. 4B is an equivalent circuit of one of the pixels illustrated in FIG. 4A. FIG. 4C is a plan view of the display panel according to some embodiments of the present disclosure.

Referring to FIG. 4A, the display device ED may include the display panel DP, a timing controller T-C, a scan driver SDV, a data driver DDV, a light emission driver EDV, and a voltage generator VG.

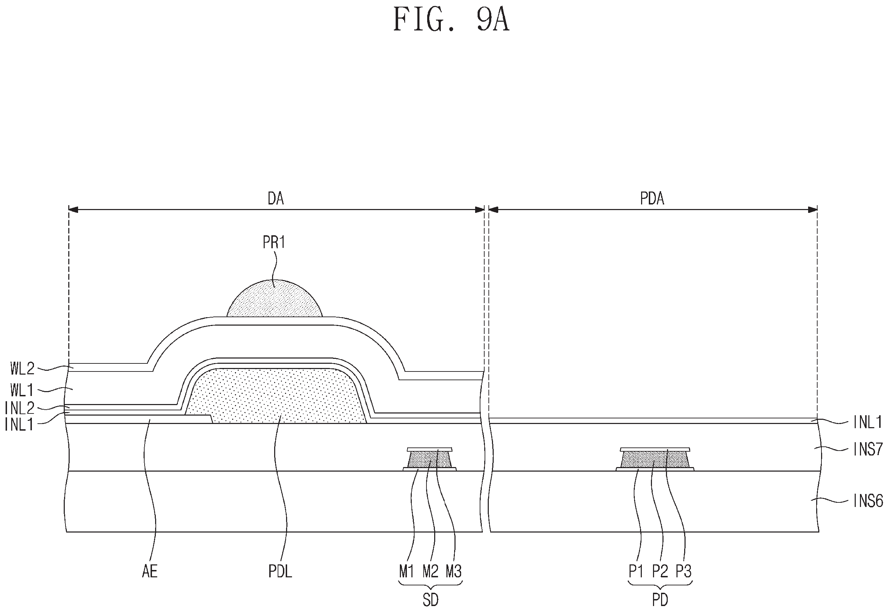

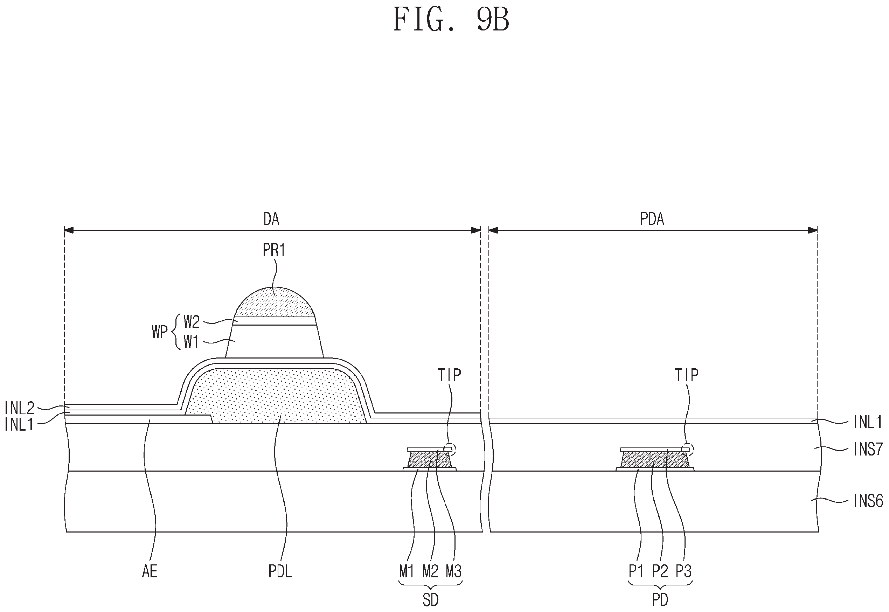

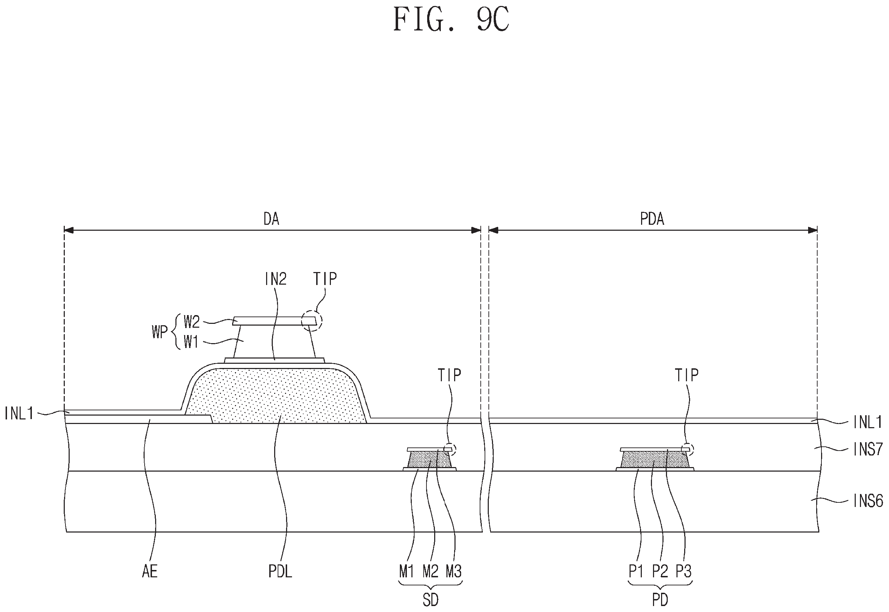

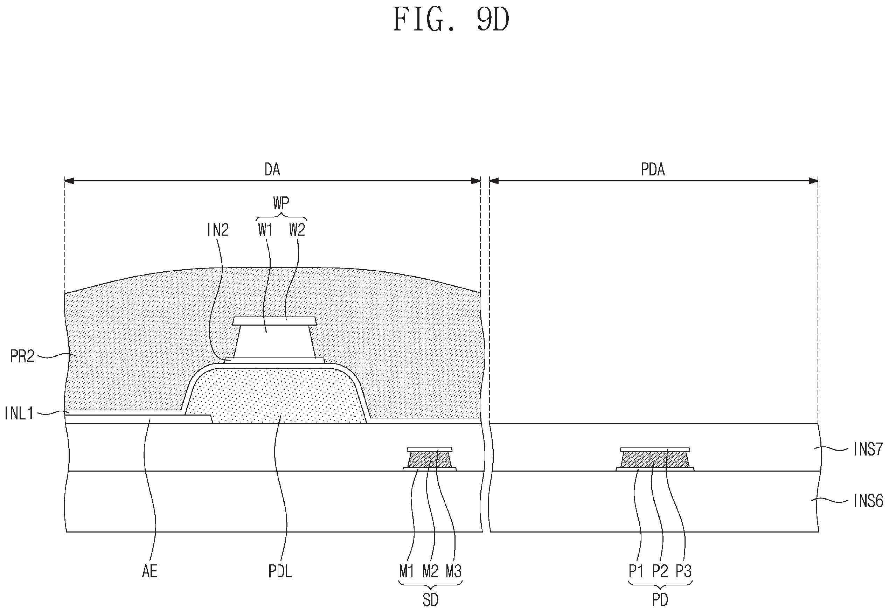

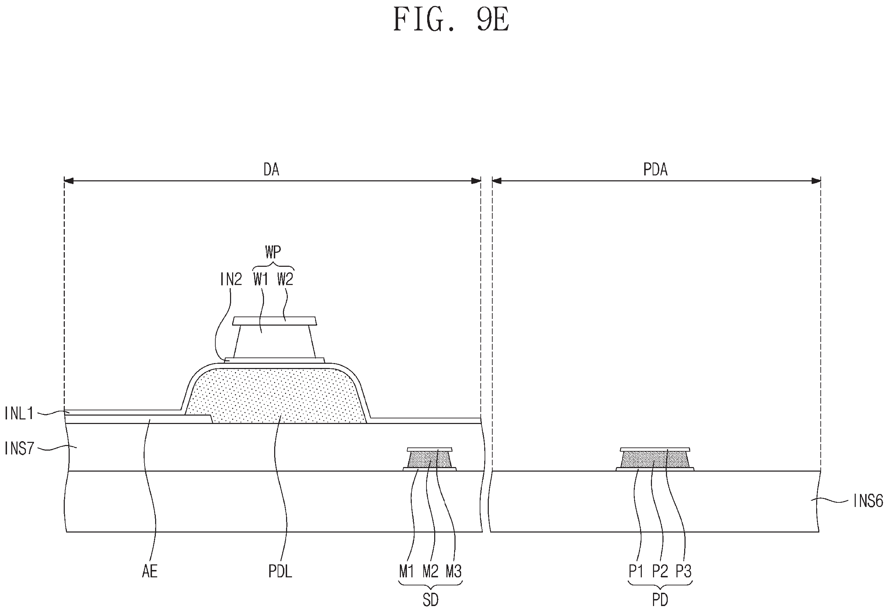

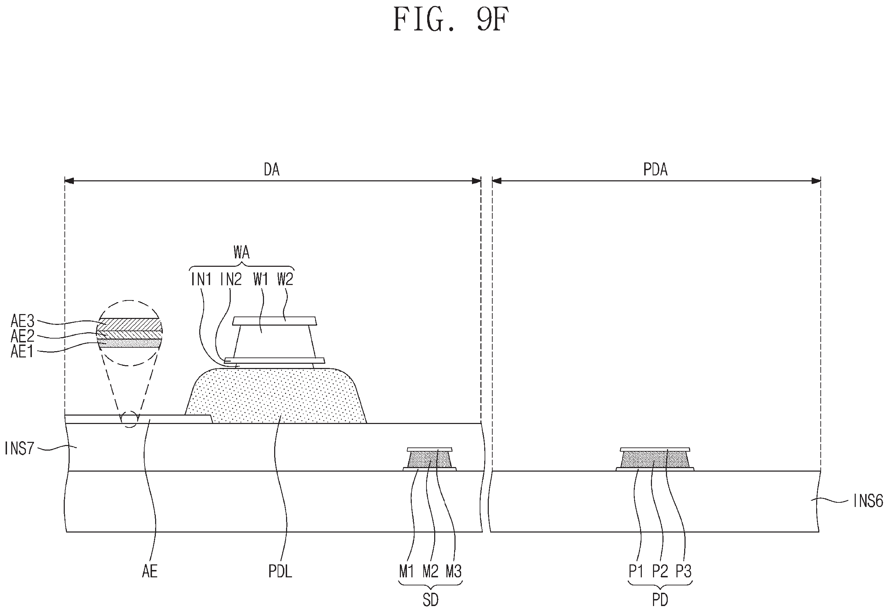

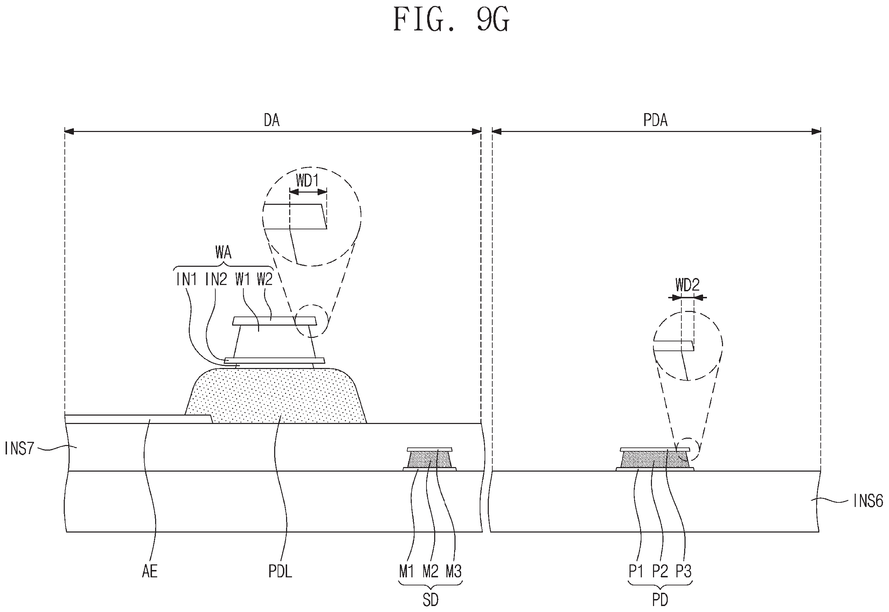

According to some embodiments, the scan driver SDV may be located in the non-display area NDA of the display panel DP described with reference to FIG. 3. According to the present disclosure, the area where the scan driver SDV is located in the non-display area NDA may be defined as a scan area SCA (refer to FIG. 9).

The scan driver SDV may include a plurality of transistors. The scan driver SDV located in the non-display area NDA may be exposed to external electrical stimulation, and protection against the electrical stimulation introduced from the outside is required.

According to the present disclosure, a guard electrode NAE (refer to FIG. 9) to which an equivalent voltage is applied and that protects the scan driver SDV from the external electrical stimulation may be located in the scan area SCA (refer to FIG. 9). Description thereabout will be given below.

The display panel DP may include a plurality of scan lines GIL1 to GILm, GCL1 to GCLm, GWL1 to GWLm, and GBL1 to GBLm, a plurality of light emission lines EML1 to EMLm, a plurality of data lines DL1 to DLn, and a plurality of pixels PX. "m" and "n" are natural numbers.

The pixels PX may be electrically connected to the scan lines GIL1 to GILm, GCL1 to GCLm, GWL1 to GWLm, and GBL1 to GBLm, the light emission lines EML1 to EMLm, and the data lines DL1 to DLn. Each of the pixels PX may be electrically connected to four corresponding scan lines, one corresponding data line, and one corresponding light emission line.

The scan lines GIL1 to GILm, GCL1 to GCLm, GWL1 to GWLm, and GBL1 to GBLm may include a plurality of initialization scan lines GIL1 to GILm, a plurality of compensation scan lines GCL1 to GCLm, a plurality of write scan lines GWL1 to GWLm, and a plurality of bias scan lines GBL1 to GBLm.

Each of the pixels PX may be connected to a corresponding one of the initialization scan lines GIL1 to GILm, a corresponding one of the compensation scan lines GCL1 to GCLm, a corresponding one of the write scan lines GWL1 to GWLm, and a corresponding one of the bias scan lines GBL1 to GBLm.

The scan lines GIL1 to GILm, GCL1 to GCLm, GWL1 to GWLm, and GBL1 to GBLm may be connected to the scan driver SDV. The scan lines GIL1 to GILm, GCL1 to GCLm, GWL1 to GWLm, and GBL1 to GBLm may extend in the first direction DR1 and may be arranged in the second direction DR2. The light emission lines EML1 to EMLm may be connected to the light emission driver EDV. The light emission lines EML1 to EMLm may extend in the first direction DR1 and may be arranged in the second direction DR2. The data lines DL1 to DLn may be connected to the data driver DDV. The data lines DL1 to DLn may extend in the second direction DR2 and may be arranged in the first direction DR1.

The scan driver SDV, the light emission driver EDV, and the data driver DDEV may be located on the display panel DP.

The timing controller T-C may receive an image signal RGB and a control signal CTRL. The timing controller T-C may generate an image data signal DAS by converting the data format of the image signal RGB according to the specification of an interface with the data driver DDV. The timing controller T-C may output a scan control signal SCS, a data control signal DCS, and a light emission control signal ECS in response to the control signal CTRL.

The voltage generator VG may generate voltages required for operation of the display panel DP. The voltage generator VG may generate a first driving voltage ELVDD, a second driving voltage ELVSS, a first initialization voltage VINT, and a second initialization voltage VAINT. The first driving voltage ELVDD, the second driving voltage ELVSS, the first initialization voltage VINT, and the second initialization voltage VAINT may be applied to the pixels PX.

The scan driver SDV may receive the scan control signal SCS from the timing controller T-C. The scan driver SDV may output scan signals to the scan lines GIL1 to GILm, GCL1 to GCLm, GWL1 to GWLm, and GBL1 to GBLm in response to the scan control signal SCS. The scan signals may be applied to the pixels PX through the scan lines GIL1 to GILm, GCL1 to GCLm, GWL1 to GWLm, and GBL1 to GBLm.

The data driver DDV may receive the data control signal DCS and the image data signal DAS from the timing controller T-C. The data driver DDV may convert the image data signal DAS into data signals and may output the data signals. The data signals may be defined as analog voltages corresponding to the grayscale level of the image data signal DAS. The data signals may be applied to the pixels PX through the data lines DL1 to DLn.

The light emission driver EDV may receive the light emission control signal ECS from the timing controller T-C. The light emission driver EDV may output light emission signals to the light emission lines EML1 to EMLm in response to the light emission control signal ECS. The light emission signals may be applied to the pixels PX through the light emission lines EML1 to EMLm.

The pixels PX may receive the data voltages in response to the scan signals. The pixels PX may display images by emitting light having luminance corresponding to the data voltages in response to the light emission signals.

FIG. 4B is a view illustrating an equivalent circuit of one of the pixels illustrated in FIG. 4A. Although FIG. 4B illustrates various components in a pixel according to some embodiments, embodiments according to the present disclosure are not limited thereto, and according to some embodiments, the pixel may include additional components, or fewer components, without departing from the scope of embodiments according to the present disclosure.

For example, in FIG. 4B, the pixel PXij connected to the j-th data line DLj, the i-th scan lines GWLi, GCLi, GILi, and GBLi, and the i-th light emission line EMLi is illustrated. "i" and "j" are natural numbers.

Referring to FIG. 4B, the pixel PXij may include a pixel circuit PC and a light emitting element OLED connected to the pixel circuit PC. The pixel circuit PC may drive the light emitting element OLED.

The pixel circuit PC may include a plurality of transistors T1 to T8 and a capacitor CST. The transistors T1 to T8 and the capacitor CST may control the amount of current flowing through the light emitting element OLED. The light emitting element OLED may generate light having a certain luminance depending on the amount of current supplied thereto.

The i-th write scan line GWLi may receive the i-th write scan signal GWi, and the i-th compensation scan line GCLi may receive the i-th compensation scan signal GCi. The i-th initialization scan line GILi may receive the i-th initialization scan signal Gli, and the i-th bias scan line GBLi may receive the i-th bias scan signal GBi. The i-th light emission line EMLi may receive the i-th light emission signal EMi.

The pixel PXij may be connected to the j-th data line DLj, the i-th write scan line GWLi, the i-th compensation scan line GCLi, the i-th initialization scan line GILi, the i-th bias scan line GBLi, the i-th light emission line EMLi, a first initialization line VIL1, a second initialization line VIL2, a bias line VBL, a first power line PL1, and a second power line PL2.

The first initialization line VIL1 may receive the first initialization voltage VINT, and the second initialization line VIL2 may receive the second initialization voltage VAINT. The bias line VBL may receive a bias voltage VBIAS. The first power line PL1 may receive the first driving voltage ELVDD, and the second power line PL2 may receive the second driving voltage ELVSS.

Each of the transistors T1 to T8 may include a source electrode, a drain electrode, and a gate electrode. Hereinafter, in FIG. 4B, for convenience, one of the source electrode and the drain electrode is defined as a first electrode, and the other is defined as a second electrode. In addition, the gate electrode is defined as a control electrode.

The transistors T1 to T8 may include the first to eighth transistors T1 to T8. The first, second, and fifth to eighth transistors T1, T2, and T5 to T8 may be PMOS transistors. The third transistor T3 and the fourth transistor T4 may be NMOS transistors.

The first transistor T1 may be defined as a driving transistor, and the second transistor T2 may be defined as a switching transistor. The third transistor T3 may be defined as a compensation transistor. The fourth transistor T4 and the seventh transistor T7 may be defined as initialization transistors. The fifth transistor T5 and the sixth transistor T6 may be defined as light emission control transistors. The eighth transistor T8 may be defined as a bias transistor.

The light emitting element OLED may be defined as an organic light emitting element. The light emitting element OLED may include a first electrode AE and a second electrode CE. The first electrode AE may receive the first driving voltage ELVDD through the sixth transistor T6, the first transistor T1, and the fifth transistor T5. The first driving voltage ELVDD may be applied to the pixel circuit PC through the first power line PL1.

The second electrode CE may receive the second driving voltage ELVSS having a lower level than the first driving voltage ELVDD. The second driving voltage ELVSS may be applied to the pixel circuit PC through the second power line PL2.

The first transistor T1 may be located between the fifth transistor T5 and the sixth transistor T6 and may be connected to the fifth transistor T5 and the sixth transistor T6. The first transistor T1 may be connected to the first power line PL1 through the fifth transistor T5 and may be connected to the first electrode AE through the sixth transistor T6.

The first transistor T1 may include the first electrode connected to the first power line PL1 through the fifth transistor T5, the second electrode connected to the first electrode AE through the sixth transistor T6, and the control electrode connected to a first node N1.

The first electrode of the first transistor T1 may be connected to the fifth transistor T5, and the second electrode of the first transistor T1 may be connected to the sixth transistor T6. The first transistor T1 may control the amount of current flowing through the light emitting element OLED depending on the voltage of the first node N1 applied to the control electrode of the first transistor T1.

The second transistor T2 may be located between the first transistor T1 and the j-th data line DLj and may be connected to the first transistor T1 and the j-th data line DLj. The second transistor T2 may include the first electrode connected to the j-th data line DLj, the second electrode connected to the first electrode of the first transistor T1, and the control electrode connected to the i-th write scan line GWLi.

The second transistor T2 may be turned on by the i-th write scan signal GWi applied through the i-th write scan line GWLi and may electrically connect the j-th data line DLj and the first electrode of the first transistor T1. The second transistor T2 may perform a switching operation of providing a data voltage VD (corresponding to the above-described data signal) applied through the j-th data line DLj to the first electrode of the first transistor T1.

The third transistor T3 may be connected to the second electrode of the first transistor T1 and the first node N1. The third transistor T3 may include the first electrode connected to the second electrode of the first transistor T1, the second electrode connected to the first node N1, and the control electrode connected to the i-th compensation scan line GCLi.

The third transistor T3 may be turned on by the i-th compensation scan signal GCi applied through the i-th compensation scan line GCLi and may electrically connect the second electrode of the first transistor T1 and the control electrode of the first transistor T1. When the third transistor T3 is turned on, the first transistor T1 and the third transistor T3 may be connected in the form of a diode.

The fourth transistor T4 may be connected to the first node N1. The fourth transistor T4 may include the first electrode connected to the first node N1, the second electrode connected to the first initialization line VIL1, and the control electrode connected to the i-th initialization scan line GILi. The fourth transistor T4 may be turned on by the i-th initialization scan signal Gli applied through the i-th initialization scan line GILi and may provide the first initialization voltage VINT applied through the first initialization line VIL1 to the first node N1.

The fifth transistor T5 may include the first electrode connected to the first power line PL1, the second electrode connected to the first electrode of the first transistor T1, and the control electrode connected to the i-th light emission line EMLi.

The sixth transistor T6 may include the first electrode connected to the second electrode of the first transistor T1, the second electrode connected to the first electrode AE, and the control electrode connected to the i-th light emission line EMLi.

The fifth transistor T5 and the sixth transistor T6 may be turned on by the i-th light emission signal EMi applied through the i-th light emission line EMLi. The first driving voltage ELVDD may be provided to the light emitting element OLED by the turned-on fifth transistor T5 and the turned-on sixth transistor T6, and a driving current may flow through the light emitting element OLED. Accordingly, the light emitting element OLED may emit light.

The seventh transistor T7 may include the first electrode connected to the first electrode AE, the second electrode connected to the second initialization line VIL2, and the control electrode connected to the i-th bias scan line GBLi. The seventh transistor T7 may be turned on by the i-th bias scan signal GBi applied through the i-th bias scan line GBLi and may provide the second initialization voltage VAINT received through the second initialization line VIL2 to the first electrode AE of the light emitting element OLED.

According to some embodiments of the present disclosure, the second initialization voltage VAINT may have a level different from that of the first initialization voltage VINT. However, without being limited thereto, the second initialization voltage VAINT may have the same level as the first initialization voltage VINT.

The seventh transistor T7 may relatively improve the ability of the pixel PXij to express black. When the seventh transistor T7 is turned on, a parasitic capacitor of the light emitting element OLED may be discharged. Accordingly, when implementing black luminance, the light emitting element OLED may not emit light due to leakage current of the first transistor T1, and thus the ability to express black may be relatively improved.

The capacitor CST may include a first electrode connected to the first power line PL1 and a second electrode connected to the first node N1. When the fifth transistor T5 and the sixth transistor T6 are turned on, the amount of current flowing through the first transistor T1 may be determined depending on the voltage stored in the capacitor CST.

The eighth transistor T8 may include the first electrode connected to the bias line VBL, the second electrode connected to the first electrode of the first transistor T1, and the control electrode connected to the i-th bias scan line GBLi.

The eighth transistor T8 may be turned on by the i-th bias scan signal GBi and may provide the bias voltage VBIAS applied through the bias line VBL to the first electrode of the first transistor T1. However, transistors included in the pixel PXij of embodiments are not limited thereto.

Referring to FIG. 4C, the display panel DP according to some embodiments of the present disclosure may be divided into a first area B1, a second area B2, and a third area B3 arranged in the first direction DR1. The width of the first area B1 in the second direction DR2 may be greater than the widths of the second area B2 and the third area B3 in the second direction DR2. The second area B2 may be bent about a virtual bending axis extending in the second direction DR2, and the third area B3 and a flexible circuit film FCB connected to the third area B3 may be arranged to face the rear surface of the first area B1.

The display panel DP according to some embodiments may include a display area DA where the pixels PX are located and a non-display area NDA around the display area DA. The display area DA and the non-display area NDA correspond to the display area DA and the non-display area NDA described with reference to FIG. 3A, respectively. The display area DA corresponds to the area where the pixels PX are located in the first area B1, and the non-display area NDA is defined as the remaining area other than the area where the pixels PX are located. Each of the pixels PX illustrated in FIG. 4C may correspond to the pixel PXij described with reference to FIG. 4B.

The first area B1 may include the display area DA and a portion of the non-display area NDA, and the second area B2 and the third area B3 may include the remaining portion of the non-display area NDA.

The scan driver SDV, the light emission driver EDV, pads PD, and a driver chip DIC may be located in the non-display area NDA of the display panel DP. According to some embodiments, the driver chip DIC may be the data driver DDV described with reference to FIG. 4A.

The display panel DP may include the plurality of pixels PX, the plurality of scan lines GWL1 to GWLm, the plurality of data lines DL1 to DLn, the plurality of light emission lines EML1 to EMLm, a first control line CSL1, a second control line CSL2, a power line PL, and the plurality of pads PD. Here, "m" and "n" are natural numbers greater than 0. The pixels PX may be connected to the scan lines GWL1 to GWLm, the data lines DL1 to DLn, and the light emission lines EML1 to EMLm. In FIG. 4C, only the write scan lines GWL1 to GWLm among the scan lines described with reference to FIG. 4B are illustrated.

The write scan lines GWL1 to GWLm may extend in the second direction DR2 and may be connected to the scan driver SDV. The data lines DL1 to DLn may extend in the first direction DR1 and may be connected to the driver chip DIC located in the third area B3 via the second area B2 from the first area B1. The light emission lines EML1 to EMLm may extend in the second direction DR2 and may be connected to the light emission driver EDV.

The power line PL may include a portion that extends in the first direction DR1 and a portion that extends in the second direction DR2. According to some embodiments, the portion extending in the first direction DR1 and the portion extending in the second direction DR2 may be located on different layers. The portion of the power line PL that extends in the first direction DR1 may extend from the first area B1 to the third area B3 via the second area B2.

The first control line CSL1 may be connected to the scan driver SDV and may extend from the first area B1 to the third area B3 via the second area B2. The second control line CSL2 may be connected to the light emission driver EDV and may extend from the first area B1 to the third area B3 via the second area B2.

The pads PD may be located adjacent to the end of the third area B3. The driver chip DIC, the power line PL, the first control line CSL1, and the second control line CSL2 may be connected to the pads PD.

The flexible circuit film FCB may overlap the end of the third area B3 of the display panel DP and may be located on the display panel DP. The flexible circuit film FCB may include pads corresponding to the pads PD and may be electrically connected to the pads PD through an anisotropic conductive film (ACF).

The pads PD may be located on the same layer as any one of the conductive lines located in the display area DA and may include the same material as the conductive line. For example, each of the pads PD may include a first conductive pattern including titanium, a second conductive pattern including aluminum, and a third conductive pattern including titanium. The second conductive pattern may have a smaller width than the first conductive pattern and the third conductive pattern. Accordingly, the third conductive pattern and the second conductive pattern may form a tip structure. Description thereabout will be given below.

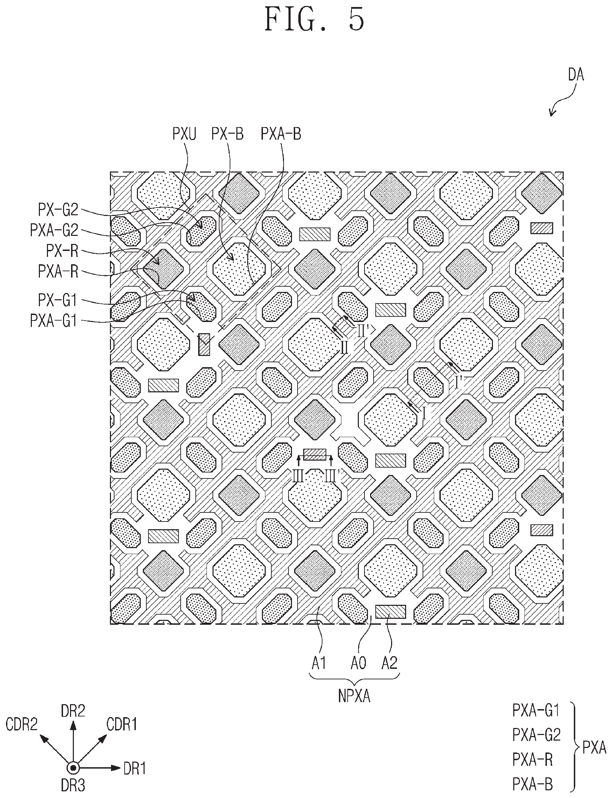

FIG. 5 is a plan view of the display area according to some embodiments of the present disclosure.

Referring to FIG. 5, according to some embodiments, one pixel unit PXU may include the pixels described with reference to FIGS. 4A and 4B. A plurality of pixel units PXU may be provided. The pixel units PXU may be arranged in the first direction DR1 and the second direction DR2 in the display area DA.

The pixel unit PXU according to some embodiments may include first to third-second pixels PX-R, PX-B, PX-G1, and PX-G2. The first to third-second pixels PX-R, PX-B, PX-G1, and PX-G2 may correspond to the pixel PXij described with reference to FIG. 4B.

The first pixel PX-R may provide red light. The light generated from the first pixel PX-R may be provided to the display area DA through a first light emitting area PXA-R. The first light emitting area PXA-R may be spaced apart from a second light emitting area PXA-B in the first direction DR1. The first light emitting area PXA-R may be spaced apart from a third-first light emitting area PXA-G1 in a second oblique direction CDR2 and may be spaced apart from a third-second light emitting area PXA-G2 in a first oblique direction CDR1. According to some embodiments, the first light emitting area PXA-R may have an octagonal rhombus shape. According to some embodiments, the first light emitting area PXA-R may have a circular shape or an oval shape.

The second pixel PX-B may provide blue light. The light generated from the second pixel PX-B may be provided to the display area DA through the first light emitting area PXA-B. The second light emitting area PXA-B may be spaced apart from the third-first light emitting area PXA-G1 in the first oblique direction CDR1 and may be spaced apart from the third-second light emitting area PXA-G2 in the second oblique direction CDR2. According to some embodiments, the second light emitting area PXA-B may have an octagonal rhombus shape. According to some embodiments, the second light emitting area PXA-B may have a circular shape or an oval shape.

The third-first pixel PX-G1 may provide green light. The light generated from the third-first pixel PX-G1 may be provided to the display area DA through the third-first light emitting area PXA-G1. According to some embodiments, the third-first light emitting area PXA-G1 may have an octagonal shape extending in the second oblique direction CDR2. According to some embodiments, the third-first light emitting area PXA-G1 may have a circular shape or an oval shape.

The third-second pixel PX-G2 may provide the same green light as the third-first pixel PX-G1. The light generated from the third-second pixel PX-G2 may be provided to the display area DA through the third-second light emitting area PXA-G2. The third-second light emitting area PXA-G2 may be spaced apart from the third-first light emitting area PXA-G1 in the second direction DR2. According to some embodiments, the third-second light emitting area PXA-G2 may have an octagonal shape extending in the first oblique direction CDR1. According to some embodiments, the third-first light emitting area PXA-G1 may have a circular shape or an oval shape.

According to some embodiments, the area of the first light emitting area PXA-R may be greater than the area of the third-first light emitting area PXA-G1 and the area of the third-second light emitting area PXA-G2 and may be smaller than the area of the second light emitting area PXA-B.

The area between the first to third-second light emitting areas PXA-R, PXA-B, PXA-G1, and PXA-G2 may be defined as a non-light emitting area NPXA.

The non-light emitting area NPXA according to some embodiments of the present disclosure may include a normal area A0, a barrier wall area A1, and support areas A2. The barrier wall area A1 and the support areas A2 may be surrounded by the normal area A0. The barrier wall area A1 and the support areas A2 may be spaced apart from each other with the normal area A0 therebetween.

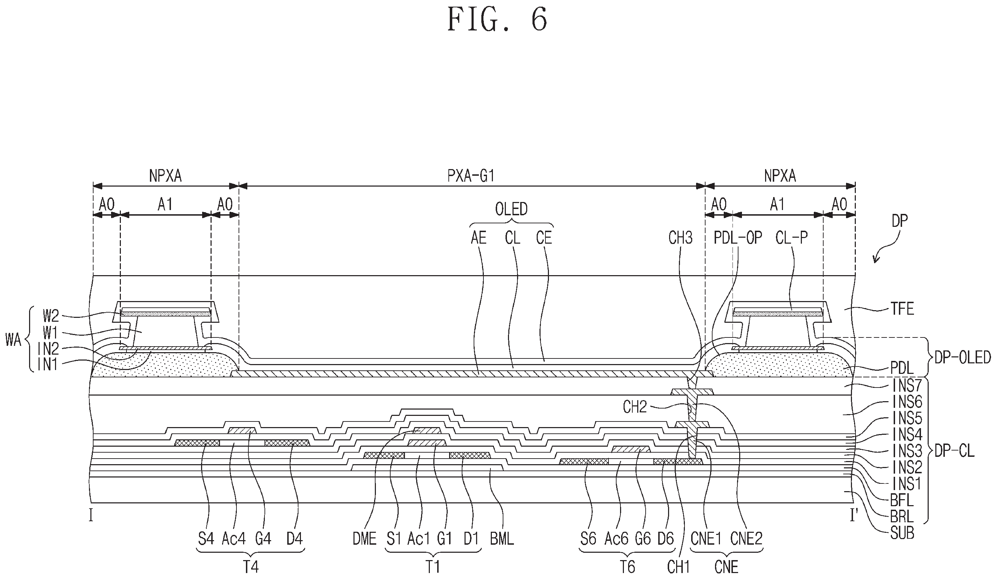

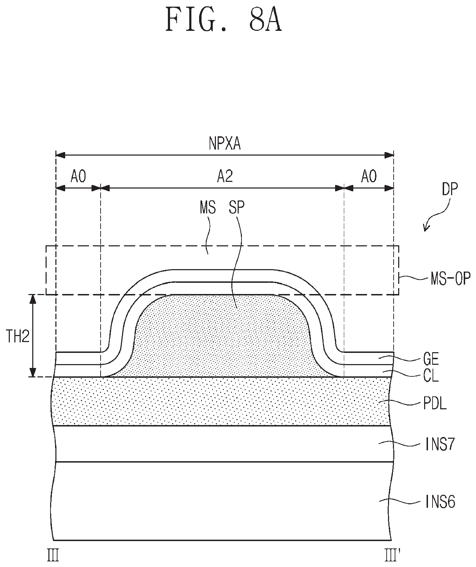

In this specification, the barrier wall area A1 may be defined as an area where a barrier wall WA (refer to FIG. 6) is located on a pixel defining layer PDL (refer to FIG. 6). The support areas A2 may be defined as areas where a spacer SP (refer to FIG. 8A) is located on the pixel defining layer PDL (refer to FIG. 6). The spacer SP (refer to FIG. 8A) may be a structure that supports a mask MS (refer to FIG. 8A). Description thereabout will be given below.

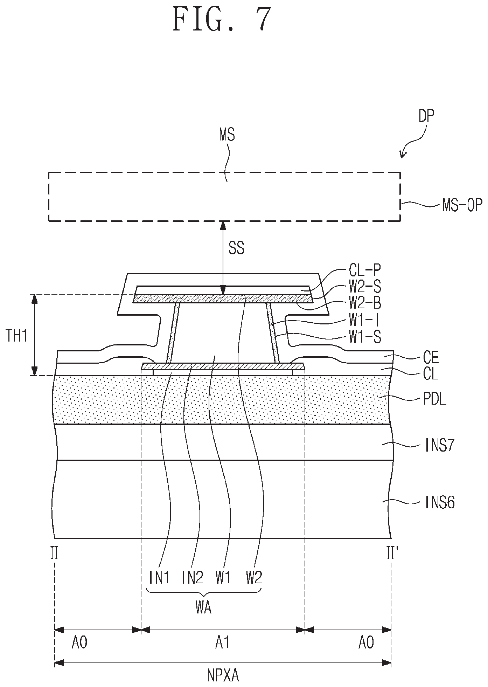

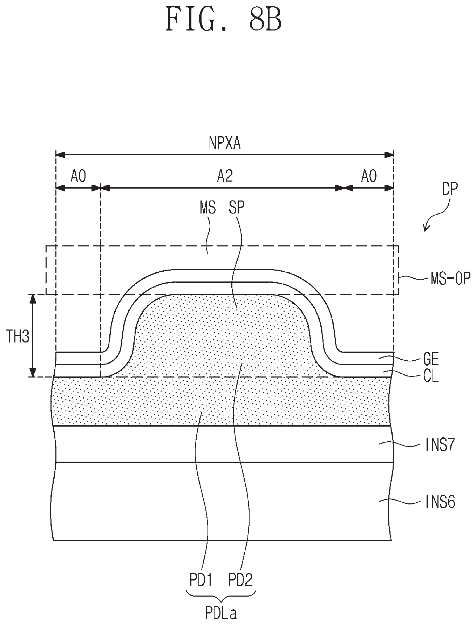

FIG. 6 is a sectional view taken along the line I-I' of FIG. 5. FIG. 7 is a sectional view taken along the line II-II' of FIG. 5. FIG. 8A is a sectional view taken along the line III-III' of FIG. 5. FIG. 8B is a sectional view of a portion of the display area according to some embodiments of the present disclosure.

FIG. 6 illustrates a sectional view of the third-first pixel PX-G1 and an area adjacent to the third-first pixel PX-G1 of FIG. 5. Referring to FIG. 6, a light emitting element OLED according to some embodiments may include a first electrode AE, a second electrode CE, and a common layer CL. The common layer CL may include a hole control layer, an electron control layer, and a light emitting layer.

The second electrode CE may be located over the first electrode AE, and the common layer CL may be located between the first electrode AE and the second electrode CE. The light emitting element OLED according to some embodiments may further include a protective layer located on the second electrode CE. The protective layer may include an organic material and may prevent or reduce instances of components located under the protective layer being damaged in a subsequent process. According to some embodiments, the protective layer may be omitted.

The first transistor T1, the fourth transistor T4, the sixth transistor T6, and the light emitting element OLED may be located on the substrate SUB. The display area DA may include the third-first light emitting area PXA-G1 corresponding to the pixel PXij (refer to FIG. 4B) and the non-light emitting area NPXA adjacent to the third-first light emitting area PXA-G1.

The substrate SUB may include glass or may include a flexible plastic material such as polyimide (PI). The circuit element layer DP-CL, the display element layer DP-OLED, and the thin film encapsulation layer TFE may be located on the substrate SUB. The circuit element layer DP-CL may be located on the substrate SUB. The circuit element layer DP-CL may include insulating layers and conductive patterns. The display element layer DP-OLED may include the light emitting element OLED and the pixel defining layer PDL.

A barrier layer BRL may be located on the substrate SUB. The barrier layer BRL may increase the coupling force between the semiconductor patterns included in the transistors and the substrate SUB. The barrier layer BRL may include an inorganic material.

A metal layer BML may be located on the barrier layer BRL. The metal layer BML may overlap the first transistor T1. According to some embodiments, the metal layer BML may have a constant voltage applied thereto. When the constant voltage is applied to the metal layer BML, the threshold voltage Vth of the first transistor T1 located over the metal layer BML may be maintained without change.

The metal layer BML may block light incident toward the first transistor T1 from below the metal layer BML. The metal layer BML may include a reflective metal. According to some embodiments, the metal layer BML may be omitted.

A buffer layer BFL may be located on the barrier layer BRL and may cover the metal layer BML. The buffer layer BFL may include an inorganic material.

A semiconductor layer S1, Ac1, and D1 of the first transistor T1 and a semiconductor layer S6, Ac6, and D6 of the sixth transistor T6 may be located on the buffer layer BFL. The semiconductor layer S1, Ac1, and D1 and the semiconductor layer S6, Ac6, and D6 may include poly silicon. However, without being limited thereto, the semiconductor layer S1, Ac1, and D1 and the semiconductor layer S6, Ac6, and D6 may include amorphous silicon.

The semiconductor layer S1, Ac1, and D1 and the semiconductor layer S6, Ac6, and D6 may be doped with an N-type dopant or a P-type dopant. The semiconductor layer S1, Ac1, and D1 and the semiconductor layer S6, Ac6, and D6 may each include highly doped areas and a lightly doped area. The highly doped areas may have a higher conductivity than the lightly doped areas and may serve as the source and drain electrodes of the first transistor T1 and the sixth transistor T6. The lightly doped areas may correspond to the active areas (or, the channel areas) of the first transistor T1 and the sixth transistor T6.

The first source area S1, the first channel area Ac1, and the first drain area D1 of the first transistor T1 may be formed from the semiconductor layer S1, Ac1, and D1. The sixth source area S6, the sixth channel area Ac6, and the sixth drain area D6 of the sixth transistor T6 may be formed from the semiconductor layer S6, Ac6, and D6. The first channel area Ac1 may be located between the first source area S1 and the first drain area D1. The sixth channel area Ac6 may be located between the sixth source area S6 and the sixth drain area D6.

A first insulating layer INS1 may be located on the buffer layer BFL to cover the semiconductor layer S1, Ac1, and D1 and the semiconductor layer S6, Ac6, and D6. The first gate electrode G1 (or, the control electrode) of the first transistor T1 and the sixth gate electrode G6 (or, the control electrode) of the sixth transistor T6 may be located on the first insulating layer INS1. When viewed from above the plane (or in a plan view), the first gate electrode G1 may overlap the first channel area Ac1, and the sixth gate electrode G6 may overlap the sixth channel area Ac6.

According to some embodiments, the structure of the source area, the channel area, the drain area, and the gate electrode of each of the second transistor T2, the fifth transistor T5, and the seventh transistor T7 may be the same (or substantially the same) as those of the first transistor T1 and the sixth transistor T6.

A second insulating layer INS2 may be located on the first insulating layer INS1 to cover the first gate electrode G1 and the sixth gate electrode G6. A dummy electrode DME may be located on the second insulating layer INS2. The dummy electrode DME may be located over the first gate electrode G1 and may overlap the first gate electrode G1 when viewed from above the plane (or in a plan view). The dummy electrode DME may form the above-described capacitor together with the first gate electrode G1.

A third insulating layer INS3 may be located on the second insulating layer INS2 to cover the dummy electrode DME. A semiconductor layer S4, Ac4, and D4 of the fourth transistor T4 may be located on the third insulating layer INS3. The semiconductor layer S4, Ac4, and D4 may include an oxide semiconductor formed of metal oxide. The oxide semiconductor may include a crystalline or amorphous oxide semiconductor.

The semiconductor layer S4, Ac4, and D4 may include a plurality of areas distinguished from each other depending on whether the metal oxide is reduced or not. The area where the metal oxide is reduced (hereinafter, referred to as the reduced area) may have a higher conductivity than the area where the metal oxide is not reduced (hereinafter, referred to as the non-reduced area). The reduced area may serve as the source electrode or the drain electrode of the fourth transistor T4. The non-reduced area may correspond to the active area (or, the channel area) of the fourth transistor T4.

The fourth source area S4, the fourth channel area Ac4, and the fourth drain area D4 of the fourth transistor T4 may be formed from the semiconductor layer S4, Ac4, and D4. The fourth channel area Ac4 may be located between the fourth source area S4 and the fourth drain area D4.

A fourth insulating layer INS4 may be located on the third insulating layer INS3 to cover the semiconductor layer S4, Ac4, and D4. The fourth gate electrode G4 of the fourth transistor T4 may be located on the fourth insulating layer INS4. When viewed from above the plane (or in a plan view), the fourth gate electrode G4 may overlap the fourth channel area Ac4.

A fifth insulating layer INS5 may be located on the fourth insulating layer INS4 to cover the fourth gate electrode G4. According to some embodiments, the structure of the source area, the channel area, the drain area, and the gate electrode of the third transistor T3 may be the same (or substantially the same) as that of the fourth transistor T4.

The barrier layer BRL, the buffer layer BFL, and the first to fifth insulating layers INS1 to INS5 may include an inorganic material. For example, the barrier layer BRL, the buffer layer BFL, and the first to fifth insulating layers INS1 to INS5 may include either silicon oxide or silicon nitride, or one insulating layer may include a plurality of inorganic layers and is not limited to any one embodiment.

The plurality of inorganic layers may have a structure in which layers including silicon nitride and silicon oxide are alternately stacked. According to some embodiments, in addition to the first to fifth insulating layers INS1 to INS5, an insulating layer including an inorganic material may be additionally located, or one of the first to fifth insulating layers INS1 to INS5 may be omitted.

A connecting electrode CNE may be located between the sixth transistor T6 and the light emitting element OLED. The connecting electrode CNE may electrically connect the sixth transistor T6 and the light emitting element OLED. The connecting electrode CNE may include a first connecting electrode CNE1 and a second connecting electrode CNE2 located on the first connecting electrode CNE1.

The first connecting electrode CNE1 may be located on the fifth insulating layer INS5 and may be connected to the sixth drain area D6 through a first contact hole CH1 defined in the first to fifth insulating layers INS1 to INS5. A sixth insulating layer INS6 may be located on the fifth insulating layer INS5 to cover the first connecting electrode CNE1.

The second connecting electrode CNE2 may be located on the sixth insulating layer INS6. The second connecting electrode CNE2 may be connected to the first connecting electrode CNE1 through a second contact hole CH2 defined in the sixth insulating layer INS6.

A seventh insulating layer INS7 may be located on the sixth insulating layer INS6 to cover the second connecting electrode CNE2 and the first power line PL1. The sixth insulating layer INS6 and the seventh insulating layer INS7 may include an organic material. According to some embodiments, in addition to the sixth insulating layer INS6 and the seventh insulating layer INS7, an insulating layer including an organic material may be additionally located, or one of the sixth insulating layer INS6 and the seventh insulating layer INS7 may be omitted.

The pixel defining layer PDL may be located on the seventh insulating layer INS7. The pixel defining layer PDL may have an opening PDL-OP defined therein to expose at least a portion of the first electrode AE. A plurality of openings PDL-OP may be provided depending on the number of first electrodes AE. The openings PDL-OP may correspond to the first to third-second light emitting areas PXA-R, PXA-B, PXA-G1, PXA-G2 described above.

The first electrode AE may be connected to the second connecting electrode CNE2 through a third contact hole CH3 defined in the seventh insulating layer INS7.

According to some embodiments, the pixel defining layer PDL may include an organic material. In addition, the pixel defining layer PDL may have a certain color and is not limited to any one embodiment.

The common layer CL and the second electrode CE included in the light emitting element OLED may be located on the first electrode AE exposed by the opening PDL-OP of the pixel defining layer PDL.

The second electrode CE may be an integrated pattern commonly arranged in the pixels. The second electrode CE may be connected by the barrier wall WA. The common layer CL may be disconnected by the barrier wall WA.

The barrier wall WA may be located on the pixel defining layer PDL. The area where the pixel defining layer PDL is located may be defined as the non-light emitting area NPXA, and the area where the barrier wall WA is located on the pixel defining layer PDL may be defined as the barrier wall area A1. The barrier wall WA will be described in more detail with reference to FIG. 7.

The thin film encapsulation layer TFE may be located on the light emitting element OLED and may cover the light emitting element OLED. The thin film encapsulation layer TFE may be located in the entire region of the display area DA. The thin film encapsulation layer TFE may include inorganic films and an organic film located between the inorganic films. The inorganic films may protect the pixels from moisture/oxygen. The organic film may protect the pixels from foreign matter such as dust particles.

As illustrated in FIG. 7, the barrier wall WA may be located on the pixel defining layer PDL. In more detail, in the non-emitting area NPXA, the barrier wall WA may be located overall on the pixel defining layer PDL except for the support areas A2.

The barrier wall WA according to some embodiments may include a first insulating pattern IN1, a second insulating pattern IN2, a first barrier wall pattern W1, and a second barrier wall pattern W2.

The first insulating pattern IN1 may be directly located on the pixel defining layer PDL. The second insulating pattern IN2 may be located on the first insulating pattern IN1. The first insulating pattern IN1 and the second insulating pattern IN2 may include different materials.

For example, the first insulating pattern IN1 may include at least one of indium zinc oxide, indium gallium zinc oxide, or indium tin oxide. The second insulating pattern IN2 may include at least one of silicon oxide, silicon oxy nitride, or silicon nitride. The second insulating pattern IN2 may have a multi-layer structure in which silicon oxide and silicon nitride are stacked.

According to some embodiments, the first insulating pattern IN1 may be a component for disconnecting a P-type hole injection layer among the layers included in the common layer CL. Accordingly, the first insulating pattern IN1 may have a greater thickness that the P-type hole injection layer among the layers included in the common layer CL.

According to some embodiments, on the cross-section, the first insulating pattern IN1 may have a smaller width than the second insulating pattern IN2. The difference in width may be formed due to the difference between the etch rates of the first insulating pattern IN1 and the second insulating pattern IN2 by an etchant.

The common layers CL included in different pixels may be disconnected from each other by the first insulating pattern IN1 and the second insulating pattern IN2 with the barrier wall WA therebetween, and the disconnected common layers CL may make contact with the side surfaces of the first insulating pattern IN1 and the second insulating pattern IN2 and the upper surface of the second insulating pattern IN2. According to some embodiments, the common layers CL may make contact with the side surface of the first barrier wall pattern W1.

The first barrier wall pattern W1 may be located on the second insulating pattern IN2. The first barrier wall pattern W1 may include a metal. For example, the first barrier wall pattern W1 may include aluminum. Because the first barrier wall pattern W1 includes aluminum, the side surface W1-S of the first barrier wall pattern W1 may be oxidized and may not have conductivity. Accordingly, the inner side W1-I of the side surface W1-S of the first barrier wall pattern W1 may be defined as a non-conductor area.

The second barrier wall pattern W2 may be located on the first barrier wall pattern W1. The second barrier wall pattern W2 may include a metal different from the metal included in the first barrier wall pattern W1. For example, the second barrier wall pattern W2 may include titanium.

According to some embodiments, the first barrier wall pattern W1 may have a greater thickness than the second barrier wall pattern W2 and may have a smaller width than the second barrier wall pattern W2.

According to some embodiments, a portion of the second barrier wall pattern W2 may protrude from the first barrier wall pattern W1 and may be exposed from the first barrier wall pattern W1. Accordingly, the lower surface W2-B of the second barrier wall pattern W2 may be exposed from the first barrier wall pattern W1. This may be formed due to the difference between the etch rates of the first barrier wall pattern W1 and the second barrier wall pattern W2 by an etchant. The shape of the first barrier wall pattern W1 and the second barrier wall pattern W2 may be defined as a "tip structure".

According to some embodiments, the mask MS may be used in the process of forming the common layer CL. The mask MS may be a fine metal mask (FMM). According to the present disclosure, the barrier wall WA located in the barrier wall area A1 may be spaced apart from the mask MS with a certain space SS therebetween in a deposition process. Accordingly, in the process using the mask MS, the barrier wall WA may not be damaged, and thus the tip structure of the barrier wall WA located in the barrier wall area A1 may be stably maintained.

The second electrode CE may extend from the third-first light emitting area PXA-G1 to the non-light emitting area PNXA and may make contact with the barrier wall WA. The second electrode CE overlapping the barrier wall WA may make contact with the side surface W1-S of the first barrier wall pattern W1, the lower surface W2-B of the second barrier wall pattern W2 exposed from the first barrier wall pattern W1, and the side surface W2-S of the second barrier wall pattern W2.

According to some embodiments, a dummy pattern CL-P may be located on the barrier wall WA. In more detail, the dummy pattern CL-P may be located between the upper surface of the second barrier wall pattern W2 and the second electrode CE. The dummy pattern CL-P may be a portion disconnected by the barrier wall WA in the process of forming the common layer CL.

As described above, the inner side W1-I of the side surface W1-S of the first barrier wall pattern W1 includes the non-conductor area that is oxidized and does not have conductivity. Accordingly, the second electrode CE that covers the barrier wall WA may be connected with another portion of the second electrode CE through the lower surface W2-B of the second barrier wall pattern W2 exposed from the first barrier wall pattern W1 and the side surface W2-S of the second barrier wall pattern W2.

According to some embodiments, the first thickness of the second electrode CE located on the common layer CL may be greater than the second thickness of the second electrode CE that covers the barrier wall WA. According to some embodiments, the second electrode CE may make contact with only a portion of the side surface W1-S of the first barrier wall pattern W1 and may be disconnected on the side surface W1-S of the first barrier wall pattern W1. The remaining portion of the second electrode CE may make contact with the side surface W2-S of the second barrier wall pattern W2 and the dummy pattern CL-P. As the second electrode CE disconnected on the barrier wall WA makes contact with the barrier wall WA including a conductive material, the second electrode CE may be electrically connected by the barrier wall WA.

According to some embodiments, the second electrode CE may extend from the display area DA to the non-display area NDA and may directly receive one of the first driving voltage ELVDD and the second driving voltage ELVSS in the non-display area NDA.

According to some embodiments, the second electrode CE may receive the first driving voltage ELVDD and the second driving voltage ELVSS through a contact structure in which additional wiring that is located on the sixth insulating layer INS6 (refer to FIG. 6) overlapping the display area DA and that receives the first driving voltage ELVDD and the second driving voltage ELVSS is connected with the barrier wall WA, and the present disclosure is not limited to any one embodiment.

FIG. 8A illustrates a sectional view of one support area A2 of the non-light emitting area NPXA.

Referring to FIG. 8A, the spacer SP may be located on the pixel defining layer PDL overlapping the support area A2. A plurality of spacers SP may be located in the non-light emitting area NPXA. The spacers SP may be randomly arranged in the non-light emitting area NPXA. The spacers SP according to the present disclosure may be surrounded by the barrier wall WA and may be spaced apart from the barrier wall WA at a certain interval.

The spacer SP may be covered by the common layer CL and the second electrode CE. The inorganic layer included in the thin film encapsulation layer TFE described with reference to FIG. 6 may be located on the barrier wall WA and the second electrode CE that covers the spacer SP.

According to some embodiments, the pixel defining layer PDL may include a colored organic material having light blocking properties. For example, the pixel defining layer PDL may be black in color. In this case, the spacer SP may include a transparent organic material such as polyimide.

According to the present disclosure, the barrier wall WA may have a first thickness TH1 (refer to FIG. 7) from the upper surface of the pixel defining layer PDL, and the spacer SP may have a second thickness TH2 from the upper surface of the pixel defining layer PDL. The second thickness TH2 of the spacer SP may be greater than the first thickness TH1 of the barrier wall WA.

Accordingly, in the process using the mask MS, the barrier wall WA may be spaced apart from the mask MS with the space SS therebetween, and the mask MS may be supported by the spacer SP. The process of forming the common layer CL may be performed while the mask MS is supported by the spacer SP. Accordingly, when the mask MS is used, the mask MS and the barrier wall WA may be spaced apart from each other, and thus the tip structure of the barrier wall WA may be more stably maintained.

FIG. 8B is a sectional view of the same area as FIG. 8A.

Referring to FIG. 8B, according to some embodiments, a pixel defining layer PDLa may have different thicknesses in the normal area A0 and the support area A2. The pixel defining layer PDLa may include a first portion PD1 entirely arranged in the non-display area NPXA and a second portion PD2 located on the support area A2. The shape of the first portion PD1 and the second portion PD2 may be formed by performing a halftone process on one organic layer. According to some embodiments, the pixel defining layer PDLa may include a transparent organic material such as polyimide.

The barrier wall WA may have a first thickness TH1 from the upper surface of the pixel defining layer PDLa, and the second portion PD2 may have a third thickness TH3 from the upper surface of the first portion PD1. According to some embodiments, the barrier wall WA may be located on the first portion PD1. The third thickness TH3 of the second portion PD2 may be greater than the first thickness TH1 of the barrier wall WA.

Accordingly, in the process using the mask MS, the barrier wall WA may be spaced apart from the mask MS with the space SS therebetween, and the mask MS may be supported by the second portion PD2. The process of forming the common layer CL may be performed while the mask MS is supported by the second portion PD2. Accordingly, when the mask MS is used, the mask MS and the barrier wall WA may be spaced apart from each other, and thus the tip structure of the barrier wall WA may be more stably maintained.

FIGS. 9A to 9G are sectional views illustrating an electronic device manufacturing method according to some embodiments of the present disclosure. Hereinafter, components identical or similar to the components described with reference to FIGS. 1A to 8B will be assigned with identical or similar reference numerals, and repetitive descriptions will be omitted. A process of forming the barrier wall WA (refer to FIG. 6) in the display area DA and a process of forming the pad PD (refer to FIG. 4C) will be simultaneously described with reference to FIGS. 9A to 9G.

In the display panel DP (refer to FIG. 6) in which the second electrode CE (refer to FIG. 6) is connected by the barrier wall WA in the display area DA as in the present disclosure, the pad PD is exposed to a developer in the process of forming the seventh insulating layer INS7, the first electrode AE (the anode in the claim), and the pixel defining layer PDL before the barrier wall WA is formed, which causes damage to the conductive pattern including aluminum among the layers included in the pad PD.

Due to this, even though a first insulating pattern layer INL1 including indium gallium zinc oxide is formed on the pad PD to protect the pad PD in a subsequent process, the damaged conductive pattern of the pad PD that includes aluminum is not covered by the first insulating pattern layer INL1, which is a protective layer, and a seam occurs.

Thereafter, when the first barrier wall pattern W1 (refer to FIG. 6) including aluminum is wet-etched in the process of forming the barrier wall WA, the conductive pattern of the pad PD that includes aluminum is etched by an AI wet etchant infiltrating through the seam. Afterward, a reliability issue may arise due to the infiltration of an organic material in the process of forming the thin film encapsulation layer TFE.

The electronic device manufacturing method to be described with reference to FIGS. 9A to 9G is aimed at providing a manufacturing method capable of solving the problem in which the conductive pattern of the pad PD that includes aluminum is etched when the barrier wall WA is formed.

The electronic device manufacturing method according to the present disclosure includes a step of forming a first organic insulating layer on a working substrate including a display area and a non-display area including a pad area, a step of forming a conductive pattern on the first organic insulating layer overlapping the pad area and forming a pad on the first organic insulating layer overlapping the pad area, a step of forming a second organic insulating layer on the first organic insulating layer to cover the conductive pattern and the pad, a step of forming an anode and a pixel defining layer on the second organic insulating layer overlapping the display area, a step of forming a first insulating pattern layer on the second organic insulating layer overlapping the display area and the non-display area, a step of forming a second insulating pattern layer on the first insulating pattern layer overlapping the display area, a step of forming a barrier wall pattern on the second insulating pattern layer overlapping the pixel defining layer, a step of forming a second insulating pattern such that the second insulating pattern overlaps the barrier wall pattern, by making the second insulating pattern layer subject to patterning, a step of forming a photoresist pattern on the first insulating pattern layer overlapping the display area, a step of removing the first insulating pattern layer overlapping the pad area, a step of forming a first insulating pattern such that the first insulating pattern overlaps the second insulating pattern, by making the first insulating pattern layer, which overlaps the display area, subject to patterning, and a step of exposing the pad by removing the second organic insulating layer overlapping the pad area.

Referring to FIG. 9A, the electronic device manufacturing method according to the present disclosure may include a step of providing the working substrate including the display area DA and the pad area PDA. The display area DA and the pad area PDA may correspond to those described with reference to FIG. 4C. Accordingly, the pad area PDA may be an area included in the non-display area NDA (refer to FIG. 4C).

According to some embodiments, the working substrate may be provided in the state in which the layers from the substrate SUB to the seventh insulating layer INS7 described with reference to FIG. 6 are formed. Hereinafter, for convenience of description, only the sixth insulating layer INS6 and the seventh insulating layer INS7 (the first organic insulating layer and the second organic insulating layer in the claim) are illustrated.

The electronic device manufacturing method according to the present disclosure may include the step of forming the conductive pattern SD on the sixth insulating layer INS6 (the first organic insulating layer in the claim) that overlaps the display area DA and the step of forming the pad PD on the sixth insulating layer INS6. According to the present disclosure, the conductive pattern SD and the pad PD formed on the sixth insulating layer INS6 may be formed by the same process and may include the same material.

The conductive pattern SD may include a lower conductive pattern M1 including titanium, an intermediate conductive pattern M2 that is located on the lower conductive pattern M1 and that includes aluminum, and an upper conductive pattern M3 located on the intermediate conductive pattern M2. The conductive pattern SD illustrates one of the patterns located between the sixth insulating layer INS6 and the seventh insulating layer INS7, but is not limited to any one embodiment as long as the conductive pattern SD is a pattern located between the sixth insulating layer INS6 and the seventh insulating layer INS7 (the second organic insulating layer in the claim).

According to some embodiments, due to the difference in etch rate between the intermediate conductive pattern M2 and the upper conductive pattern M3, the upper conductive pattern M3 may protrude from the intermediate conductive pattern M2 to form a tip. Accordingly, a portion of the upper conductive pattern M3 may be exposed from the intermediate conductive pattern M2.

The pad PD may include a first conductive pattern P1 including titanium, a second conductive pattern P2 that is located on the first conductive pattern P1 and that includes aluminum, and a third conductive pattern P3 located on the second conductive pattern P2.

According to some embodiments, due to the difference in etch rate between the second conductive pattern P2 and the third conductive pattern P3, the third conductive pattern P3 may protrude from the second conductive pattern P2 to form a tip. Accordingly, a portion of the third conductive pattern P3 may be exposed from the second conductive pattern P2.

The electronic device manufacturing method according to the present disclosure may include the step of forming the seventh insulating layer INS7 on the sixth insulating layer INS6 to cover the conductive pattern SD and the pad PD. The sixth insulating layer INS6 and the seventh insulating layer INS7 may include an organic material.

In the present disclosure, the seventh insulating layer INS7 may function as a protective layer for preventing or reducing the second conductive pattern P2 of the pad PD, which includes aluminum, being etched in the pad area PDA. Accordingly, even though a subsequent process of forming the barrier wall WA (refer to FIG. 9D) is performed, additional etching of the second conductive pattern P2 may be prevented or reduced.

The electronic device manufacturing method according to the present disclosure may include the step of forming the anode AE on the seventh insulating layer INS7 overlapping the display area DA and the step of forming the pixel defining layer PDL including the opening exposing at least a portion of the anode AE.

The anode AE may be formed in a multi-layer structure. For example, the anode AE may include a lower layer including indium tin oxide, an intermediate layer that is located on the lower layer and that includes silver (Ag), and an upper layer that is located on the intermediate layer and that includes indium tin oxide. The pixel defining layer PDL may include an organic material having a certain color.

Thereafter, the first insulating pattern layer INL1 may be formed on the seventh insulating layer INS7 that overlaps the display area DA and the pad area PDA. The first insulating pattern layer INL1 may include at least one of indium zinc oxide, indium gallium zinc oxide, or indium tin oxide. The first insulating pattern layer INL1 may cover a portion of the anode AE exposed from the opening of the pixel defining layer PDL, the pixel defining layer PDL, and the seventh insulating layer INS7 in the display area DA.

Thereafter, the second insulating pattern layer INL2 may be formed on the first insulating pattern layer INL1 overlapping the display area DA. The second insulating pattern layer INL2 may not be formed in the pad area PDA.

The second insulating pattern layer INL2 may include at least one of silicon oxide, silicon oxy nitride, or silicon nitride.

The electronic device manufacturing method according to the present disclosure may include a step of forming a first barrier wall layer WL1 and a second barrier wall layer WL2 on the second insulating pattern layer INL2 overlapping the pixel defining layer PDL. The first barrier wall layer WL1 may include aluminum, and the second barrier wall layer WL2 may include titanium.

The electronic device manufacturing method according to the present disclosure may include a step of forming a first photoresist pattern PR1 on the second barrier wall layer WL2 overlapping the pixel defining layer PDL. The first photoresist pattern PR1 may be located on a portion of the second barrier wall layer WL2 overlapping the pixel defining layer PDL and may expose the remaining portion of the second barrier wall layer WL2 that does not overlap the pixel defining layer PDL. According to some embodiments, the first photoresist pattern PR1 may not be located in the pad area PDA.

Referring to FIG. 9B, the electronic device manufacturing method according to the present disclosure may include the step of forming the barrier wall pattern WP on the second insulating pattern layer INL2 overlapping the pixel defining layer PDL. The barrier wall pattern WP may include the second barrier wall pattern W2 formed by making the second barrier wall layer WL2 subject to patterning and the first barrier wall pattern W1 formed by making the first barrier wall layer WL1 subject to patterning. The barrier wall pattern WP may be formed through a dry etching process using the first photoresist pattern PR1 as a mask.

Referring to FIG. 9C, the electronic device manufacturing method according to the present disclosure may include a step of additionally etching the first barrier wall pattern W1 including aluminum. The additional etching step may be formed through a wet etching process. Due to the difference in etch rate between the first barrier wall pattern W1 including aluminum and the second barrier wall pattern W2 including titanium, a portion of the second barrier wall pattern W2 may protrude from the first barrier wall pattern W1 to form a tip. The first photoresist pattern PR1 may be removed from the second barrier wall pattern W2.

The electronic device manufacturing method according to the present disclosure may include the step of forming the second insulating pattern IN2 located between the barrier wall pattern WP and the first insulating pattern layer INL1 by making the second insulating pattern layer INL2 subject to patterning. The patterning of the second insulating pattern layer INL2 may be performed through a dry etching process. The second insulating pattern IN2 may be formed to overlap the upper surface of the pixel defining layer PDL.

Referring to FIG. 9D, the electronic device manufacturing method according to the present disclosure may include a step of forming a second photoresist pattern PR2 on the first insulating pattern layer INL1 overlapping the display area DA. The second photoresist pattern PR2 may cover the barrier wall pattern WP in the display area DA. The second photoresist pattern PR2 may not be located in the pad area PDA. In the present disclosure, the second photoresist pattern PR2 may be located only in the display area DA to remove the first insulating pattern layer INL1 formed in the pad area PDA.

The electronic device manufacturing method according to the present disclosure may include the step of removing the first insulating pattern layer INL1 overlapping the pad area PDA. In this process, the first insulating pattern layer INL1 overlapping the display area DA may remain. The first insulating pattern layer INL1 overlapping the pad area PDA may be removed through a wet etching process. Thereafter, the second photoresist pattern PR2 may be removed from the display area DA.

Referring to FIG. 9E, the electronic device manufacturing method according to the present disclosure may include the step of removing the seventh insulating layer INS7 overlapping the pad area PDA. The step of removing the seventh insulating layer INS7 overlapping the pad area PDA may be performed through a wet etching process.

According to the present disclosure, before the seventh insulating layer INS7 overlapping the pad area PDA is removed, the second conductive pattern P2 included in the pad PD may not be exposed to a developer in different processes while the process of forming the barrier wall pattern WP is performed and may be protected by the seventh insulating layer INS7.

Accordingly, damage to the second conductive pattern P2 including aluminum may be minimized, and the above-described problem may be solved. Thus, the electronic device manufacturing method with relatively improved reliability and process yield may be provided.

Referring to FIG. 9F, the electronic device manufacturing method according to the present disclosure may include the step of forming the first insulating pattern IN1 by making the first insulating pattern layer INL1 subject to patterning. The first insulating pattern IN1 may overlap the second insulating pattern IN2 and may make contact with the pixel defining layer PDL. The patterning of the first insulating pattern layer INL1 may be performed through a wet etching process. Accordingly, the barrier wall WA may be formed on the pixel defining layer PDL.

According to some embodiments, the anode AE may be formed in a multi-layer structure. For example, the anode AE may include a lower layer AE1 including indium tin oxide, an intermediate layer AE2 that is located on the lower layer AE1 and that includes silver (Ag), and an upper layer AE3 that is located on the intermediate layer AE2 and that includes indium tin oxide.

The upper layer AE3 including indium tin oxide may be damaged in the wet etching process for removing the first insulating pattern layer INL1 that functions as a hard mask. According to some embodiments, even though the upper layer AE3 is damaged in the wet etching process for removing the first insulating pattern layer INL1, the damage may be compensated for, by making the upper layer AE3 thicker than the lower layer AE1.

Referring to FIG. 9G, when compared to the third conductive pattern P3 protected by the seventh insulating layer INS7, the first barrier wall pattern W1 included in the barrier wall WA may be exposed to a developer for a relatively long period of time and/or a relatively large number of times in a subsequent process.

Accordingly, the first width WD1 by which the second barrier wall pattern W2 is exposed from the first barrier wall pattern W1 may be greater than the second width WD2 by which the third conductive pattern P3 is exposed from the second conductive pattern P2. Here, the first width WD1 may be defined as be a distance between one end of the second barrier wall pattern and a contact point of the first barrier wall pattern and the second barrier wall pattern. The second width WD2 may be defined as be a distance between one end of the third conductive pattern and a contact point of the second conductive pattern and the third conductive pattern.

Thereafter, a step of forming the common layer CL described with reference to FIG. 6, a step of forming the second electrode CE, and a step of forming the thin film encapsulation layer TFE may be performed in the display area DA.

As discussed, embodiments can provide an electronic device comprising: a display panel including a display area and a non-display area surrounding the display area, the non-display area including a pad area; and a driver configured to receive image data and a display brightness value from a processor and to drive the display panel based on the image data and the display brightness value, wherein the display panel includes: a substrate including light emitting areas overlapping the display area and a non-light emitting area between the light emitting areas; a pixel unit overlapping the display area, the pixel unit including pixels, each of which includes a transistor and a light emitting element connected with the transistor; a pixel defining layer overlapping the non-light emitting area, the pixel defining layer having openings defined therein to overlap the light emitting areas; a barrier wall including a first barrier wall pattern on the pixel defining layer and a second barrier wall pattern on the first barrier wall pattern; and pads connected to the pixels and overlapping the non-display area, wherein each of the pads includes a first conductive pattern, a second conductive pattern on the first conductive pattern, and a third conductive pattern on the second conductive pattern, and wherein a width by which the second barrier wall pattern extends from the first barrier wall pattern is greater than a width by which the third conductive pattern extends from the second conductive pattern.

The width by which the second barrier wall pattern extends from the first barrier wall pattern may be a distance between one end of the second barrier wall pattern and a contact point of the first barrier wall pattern and the second barrier wall pattern.

An extension portion defined by the extension of the second barrier wall pattern beyond the first barrier wall pattern may be present at different sides of the barrier wall.

The width by which the third conductive pattern extends from the second conductive pattern may be a distance between one end of the third conductive pattern and a contact point of the second conductive pattern and the third conductive pattern.

An extension portion defined by the extension of the third conductive pattern beyond the second conductive pattern may be present at different sides of the pad.

The width of the second barrier wall pattern may be greater than the width of the first barrier wall pattern.

The thickness of the first barrier wall pattern may be greater than the thickness of the second barrier wall pattern.

The first barrier wall pattern may have tapered side surfaces.

The first barrier wall pattern may increase in width from its base to where it contacts the second barrier wall pattern.

The barrier wall may further include a first insulating pattern on the pixel defining layer and a second insulating pattern between the first insulating pattern and the first barrier wall pattern.

The width of the second insulating pattern may be greater than the width of the first insulating pattern.

The width of the second insulating pattern may be greater than the width of the first barrier wall pattern.

The width of the first conductive pattern may be greater than the width of the second conductive pattern.

The width of the third conductive pattern may be greater than the width of the second conductive pattern.

The width of the third conductive pattern may be greater than the width of the first conductive pattern.

The thickness of the second conductive pattern may be greater than the thickness of the first conductive pattern.

The thickness of the second conductive pattern may be greater than the thickness of the third conductive pattern.

The second conductive pattern may have tapered side surfaces.

The second conductive pattern may increase in width from where it contacts the first conductive pattern to where in contacts the third conductive pattern.

Embodiments can provide a method for manufacturing an electronic device, the method comprising: a step of forming a first organic insulating layer on a working substrate including a display area and a non-display area including a pad area; a step of forming a conductive pattern on the first organic insulating layer overlapping the pad area and forming a pad on the first organic insulating layer overlapping the pad area; a step of forming a second organic insulating layer on the first organic insulating layer to cover the conductive pattern and the pad; a step of forming an anode and a pixel defining layer on the second organic insulating layer overlapping the display area; a step of forming a first insulating pattern layer on the second organic insulating layer overlapping the display area and the pad area; a step of forming a second insulating pattern layer on the first insulating pattern layer overlapping the display area; a step of forming a barrier wall pattern on the second insulating pattern layer overlapping the pixel defining layer; a step of forming a second insulating pattern such that the second insulating pattern overlaps the barrier wall pattern, by making the second insulating pattern layer subject to patterning; a step of forming a photoresist pattern on the first insulating pattern layer overlapping the display area; a step of removing the first insulating pattern layer overlapping the pad area; a step of forming a first insulating pattern such that the first insulating pattern overlaps the second insulating pattern, by making the first insulating pattern layer subject to patterning, the first insulating pattern layer being overlapping the display area; and a step of exposing the pad by removing the second organic insulating layer overlapping the pad area.

A width by which the second barrier wall pattern extends from the first barrier wall pattern may be greater than a width by which the third conductive pattern extends from the second conductive pattern.

According to some embodiments of the present disclosure, the electrodes may be connected with each other through the barrier wall in the non-display area, and thus the electronic device may provide a relatively uniform driving voltage to the pixels.

In addition, by providing the electronic device manufacturing method capable of protecting the layer of the pad that includes aluminum, the electronic device with relatively improved display quality may be provided.

While the present disclosure has been described with reference to embodiments thereof, it will be apparent to those of ordinary skill in the art that various changes and modifications may be made thereto without departing from the scope of the present disclosure as set forth in the following claims, and their equivalents.

## Claims

1. An electronic device comprising:
a display panel including a display area and a non-display area surrounding the display area, the non-display area including a pad area; and
a driver configured to receive image data and a display brightness value from a processor and to drive the display panel based on the image data and the display brightness value,
wherein the display panel includes:
a substrate including light emitting areas overlapping the display area and a non-light emitting area between the light emitting areas;
a pixel unit overlapping the display area, the pixel unit including pixels, each of which includes a transistor and a light emitting element connected with the transistor;
a pixel defining layer overlapping the non-light emitting area, the pixel defining layer having openings defined therein to overlap the light emitting areas;
a barrier wall including a first barrier wall pattern on the pixel defining layer and a second barrier wall pattern on the first barrier wall pattern; and
pads connected to the pixels and overlapping the non-display area, wherein each of the pads includes a first conductive pattern, a second conductive pattern on the first conductive pattern, and a third conductive pattern on the second conductive pattern, and
wherein a width by which the second barrier wall pattern extends from the first barrier wall pattern is greater than a width by which the third conductive pattern extends from the second conductive pattern.

2. The electronic device of claim 1, wherein the first barrier wall pattern includes aluminum, and
wherein the second barrier wall pattern includes titanium.

3. The electronic device of claim 2, wherein the second conductive pattern includes a same material as the first barrier wall pattern, and
wherein the first conductive pattern and the third conductive pattern include a same material as the second conductive pattern.

4. The electronic device of claim 2 or 3, wherein the first barrier wall pattern has a smaller width than the second barrier wall pattern, and
wherein the first barrier wall pattern has a greater thickness than the second barrier wall pattern.

5. The electronic device of any one of claims 2 to 4, wherein the second conductive pattern has a width smaller than a width of the first conductive pattern and a width of the third conductive pattern, and
wherein the second conductive pattern has a thickness greater than a thickness of the first conductive pattern and a thickness of the third conductive pattern.

6. The electronic device of any one of claims 1 to 5, wherein the barrier wall further includes a first insulating pattern on the pixel defining layer and a second insulating pattern between the first insulating pattern and the first barrier wall pattern.

7. The electronic device of claim 6, wherein the second insulating pattern has a width greater than a width of the first barrier wall pattern and a width of the first insulating pattern.

8. The electronic device of claim 6 or 7, wherein the first insulating pattern includes at least one of indium zinc oxide, indium gallium zinc oxide, or indium tin oxide, and
wherein the second insulating pattern includes at least one of silicon oxide, silicon oxy nitride, or silicon nitride.

9. The electronic device of any one of claims 1 to 8, wherein each of the light emitting elements includes a first electrode having at least a portion exposed by an opening from among the openings, a common layer on the first electrode, and a second electrode on the common layer, and
wherein the second electrode has a one-body shape commonly included in the pixels;
optionally further comprising: a dummy pattern on an upper surface of the second barrier wall pattern, wherein the dummy pattern includes a same material as the common layer;
further optionally wherein the second electrode extends from a light emitting area from among the light emitting areas to the non-light emitting area and covers a side surface of the first barrier wall pattern, a lower surface of the second barrier wall pattern exposed from the first barrier wall pattern, and the dummy pattern.

10. The electronic device of any one of claims 1 to 9, wherein the display panel further includes a first organic insulating layer between the transistors and the light emitting elements and a second organic insulating layer on the first organic insulating layer,
wherein the pixel defining layer is on the second organic insulating layer in the display area, and
wherein a pad from among the pads is on the first organic insulating layer in the pad area;
optionally wherein the second organic insulating layer is not in the pad area.

11. The electronic device of any one of claims 1 to 10, further comprising:
a flexible circuit board in the pad area and coupled with the pads.

12. A method for manufacturing an electronic device, the method comprising:
a step of forming a first organic insulating layer on a working substrate including a display area and a non-display area including a pad area;
a step of forming a conductive pattern on the first organic insulating layer overlapping the pad area and forming a pad on the first organic insulating layer overlapping the pad area;
a step of forming a second organic insulating layer on the first organic insulating layer to cover the conductive pattern and the pad;
a step of forming an anode and a pixel defining layer on the second organic insulating layer overlapping the display area;
a step of forming a first insulating pattern layer on the second organic insulating layer overlapping the display area and the pad area;
a step of forming a second insulating pattern layer on the first insulating pattern layer overlapping the display area;
a step of forming a barrier wall pattern on the second insulating pattern layer overlapping the pixel defining layer;
a step of forming a second insulating pattern such that the second insulating pattern overlaps the barrier wall pattern, by making the second insulating pattern layer subject to patterning;
a step of forming a photoresist pattern on the first insulating pattern layer overlapping the display area;
a step of removing the first insulating pattern layer overlapping the pad area;
a step of forming a first insulating pattern such that the first insulating pattern overlaps the second insulating pattern, by making the first insulating pattern layer subject to patterning, the first insulating pattern layer being overlapping the display area; and
a step of exposing the pad by removing the second organic insulating layer overlapping the pad area.

13. The method of claim 12, wherein the first insulating pattern layer includes at least one of indium zinc oxide, indium gallium zinc oxide, or indium tin oxide, and
wherein the second insulating pattern layer includes at least one of silicon oxide, silicon oxy nitride, or silicon nitride.

14. The method of claim 12 or 13, wherein the barrier wall pattern includes a first barrier wall pattern on the second insulating pattern and including aluminum and a second barrier wall pattern on the first barrier wall pattern and including titanium;
optionally wherein each of the conductive pattern and the pad includes a first conductive pattern including titanium, a second conductive pattern on the first conductive pattern and including aluminum, and a third conductive pattern on the second conductive pattern and including titanium;
further optionally wherein a width by which the second barrier wall pattern extends from the first barrier wall pattern is greater than a width by which the third conductive pattern extends from the second conductive pattern.

15. The method of any one of claims 12 to 14, wherein the photoresist pattern is not on the first insulating pattern layer overlapping the pad area.
